(19) **Europäisches Patentamt / European Patent Office / Office européen des brevets**

(11) **EP 4 729 973 A2**

(12) **EUROPEAN PATENT APPLICATION**

(43) Date of publication:
**22.04.2026 Bulletin 2026/17**

(21) Application number: **26161392.1**

(22) Date of filing: **08.03.2024**

(51) International Patent Classification (IPC):
*G01R 33/62* $^{(2006.01)}$

(52) Cooperative Patent Classification (CPC):
**G01R 33/3621; G01R 33/3607**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **13.03.2023 US 202363489834 P**

(62) Document number(s) of the earlier application(s) in accordance with Art. 76 EPC:
**24769602.4 / 4 680 984**

(71) Applicant: **Quantum Valley Investment Fund LP Waterloo ON N2L 0A9 (CA)**

(72) Inventors:
• **BORNEMAN, Troy W.**
**Waterloo, N2L 0A9 (CA)**

• **RAVAL, Ishit**
**Waterloo, N2L 0A9 (CA)**
• **CARKNER, Donald Edward**
**Waterloo, N2L 0A9 (CA)**
• **BOORN, Andrew**
**Waterloo, N2L 0A9 (CA)**

(74) Representative: **Potter Clarkson**
**Chapel Quarter**
**Mount Street**
**Nottingham NG1 6HQ (GB)**

Remarks:
This application was filed on 27.02.2026 as a divisional application to the application mentioned under INID code 62.

(54) **DIGITAL OPERATION OF A MAGNETIC RESONANCE SYSTEM**

(57) In a general aspect, a magnetic resonance system performs a magnetic resonance measurement. In some examples, a magnetic resonance system includes data processing apparatus and a superheterodyne spectrometer system. The data processing □ apparatus generates digital intermediate frequency (IF) signal information based on a pulse profile. The digital IF signal information is configured to suppress an image sideband in a magnetic resonance control signal. The superheterodyne spectrometer generates the magnetic resonance control signal based on the digital IF signal information.

FIG. 1

**Description**

CROSS-REFERENCE TO RELATED APPLICATIONS

This application claims priority to U.S. Provisional Patent Application No. 63/489,834, filed March 13, 2023, entitled "Digital Operation of a Magnetic Resonance System." The above-referenced priority document is incorporated herein by reference in its entirety.

BACKGROUND

The following description relates to digital operation of a magnetic resonance system.

Magnetic resonance systems are used to study various types of samples and phenomena. In some magnetic resonance applications, the spins in a sample are polarized by a static, external magnetic field, and a resonator manipulates the spins by producing a magnetic field at a frequency near the spins' resonance frequencies. Applications of magnetic resonance include, for example, electron paramagnetic resonance (EPR), nuclear magnetic resonance (NMR), magnetic resonance imaging (MRI) and others.

BRIEF DESCRIPTION OF DRAWINGS

FIG. 1 is a schematic diagram showing aspects of an example magnetic resonance system.

FIG. 2A is a schematic diagram showing aspects of an example magnetic resonance system.

FIG. 2B is a schematic diagram showing aspects of an example magnetic resonance system.

FIG. 3A is a schematic diagram of an example signal processing unit of a magnetic resonance system.

FIG. 3B is a schematic diagram of an example data format of a FIFO buffer device of the example signal processing unit in FIG. 3A.

FIG. 4 is a flow diagram showing aspects of an example process.

FIG. 5A shows a time series of amplitudes and phases of pulse intervals in a pulse.

FIG. 5B is a plot showing digital IF signal values as a function of time based on the time series of amplitudes and phases of the pulse in FIG. 5A.

FIG. 5C shows a time series of amplitudes and phases of the example pulse as shown in FIG. 5A and a reconstructed pulse by demodulating the digital IF signal values in FIG. 5B.

FIG. 6A shows a time series of amplitudes and phases of a pulse in an example pulse profile, first digital IF signal values, and second digital IF signal values.

FIG. 6B shows Fourier components of a first output signal of an IQ mixer model.

FIG. 6C shows Fourier components of a third output signal of the IQ mixer model.

FIG. 7A shows a time series of amplitudes and phases of a first example pulse in a pulse sequence.

FIG. 7B shows a time series of amplitudes and phases of a second example pulse in the pulse sequence.

FIG. 7C is a plot showing digital IF signal values determined based on the time series of amplitudes and phases of the first and second example pulses in FIGS. 7A-7B.

FIG. 7D shows time series of amplitudes and phases of a pulse sequence and a reconstructed pulse sequence.

FIG. 7E is a plot showing digital IF signal values determined based on the time series of amplitudes and phases of the first and second example pulses in FIGS. 7A-7B.

FIG. 7F includes plots showing time series of amplitudes and phases of a pulse sequence and a reconstructed pulse sequence.

FIG. 7G includes a plot showing a zoomed-in view of the digital IF signal values in FIG. 7C and a plot showing a zoomed-in view of the digital IF signal values in FIG. 7E during a time window of 1465-1485 ns.

FIG. 7H is a plot showing zoomed-in views of the time series of phases of the two reconstructed pulse sequences shown in FIGS. 7D, 7F during a time window 1475-1600 ns.

FIG. 7I is a plot showing the time series of amplitudes of the second example pulse as shown in FIG. 7B and a plot showing the time series of phases of the second example pulse before and after applying a phase shift to correct the effect from the time delay.

FIG. 8 includes plots of subsets of digital IF signal values of corresponding pulses in the pulse sequence.

FIGS. 9A-9B is a plot and a corresponding table of an example hardware control sequence.

FIG. 10 is a plot showing example ADC data as a function of time.

FIG. 11A includes plots showing amplitude and phase envelopes of a first pulse and a second pulse in a pulse sequence.

FIG. 11B includes a plot showing a first subset of digital IF signal values generated based on the amplitude and phase envelopes of the first pulse shown in FIG. 11A, a plot showing a second subset of digital IF signal values generated based on the amplitude and phase envelopes of the second pulse shown in FIG. 11A, a plot showing a third subset of digital IF signal values generated by superposing the first and second subsets of digital IF signal values; and a plot showing a Fourier transform of the third subset of digital IF signal values.

FIG. 11C includes plots showing amplitude and phase envelopes of the first pulse and a first reconstructed pulse by demodulating the third subset of digital IF signal values at the first intermediate frequency, and plots showing amplitude and phase envelopes of the second pulse and a second reconstructed pulse by decomposing the third subset of digital IF signal values at the second intermediate frequency.

FIG. 12A includes plots showing amplitude and phase envelopes of a first pulse in a pulse sequence; plots showing amplitude and phase envelopes of a second pulse and a third pulse in the pulse sequence; and plots showing amplitude and phase envelopes of a fourth pulse in a pulse sequence.

FIG. 12B includes a plot showing aspects of a first set of digital IF signal values including three subsets of digital IF signal values, a plot showing aspects of a second set of digital IF signal values including a third subset of digital IF signal values, a plot showing a third set of digital IF signal value which is generated by superposing the first and second digital IF signals, and a plot showing a corresponding Fourier transform of the third set of digital IF signal values.

FIG. 12C includes plots showing amplitude and phase envelopes of an original pulse sequence and a first reconstructed pulse sequence by demodulating the third set of digital IF signal values shown in FIG. 12B at the first intermediate frequency of 150 MHz, and plots showing amplitude and phase envelopes of the original pulse sequence and a second reconstructed pulse sequence by demodulating the third set of digital IF signal values shown in FIG. 12B at the second intermediate frequency of 250 MHz.

DETAILED DESCRIPTION

In some aspects of what is described here, a magnetic resonance system includes a computer system and a superheterodyne spectrometer system. In some implementations, a controller unit (which can be implemented, for example, on a field programmable gate array (FPGA) or another type of programmable digital control unit) controls the superheterodyne spectrometer system to perform pulse transmission and signal detection. Digital pulse generation, for example, using an FPGA or another type of controller unit, can provide significant improvements and advantages; for instance, digital pulse generation can boost signal-to-noise ratio and amplitude/phase stability by avoiding noise and fluctuations associated with analog electronics. In some instances, spin control methods that take advantage of high-speed arbitrary waveform generator (AWG) capabilities can enhance control bandwidths and robustness to errors while also providing a framework to develop novel experiments that take advantage of precisely designed dynamics of a spin system.

In some instances, an intermediate frequency (IF) pulse signal is digitally generated and detected by a superheterodyne spectrometer system, which can allow for precise AWG transmission of phase-coherent pulses over arbitrary times. Advanced quantum control pulses and sequences that enhance electron paramagnetic resonance (EPR) measurement sensitivity and flexibility can be implemented with high fidelity, allowing demanding experiments to be performed with higher accuracy and precision.

In some implementations, the methods and systems presented here allow accurate implementation of arbitrary and fast shaped pulses with multiplexing capability, AWG capability with nanosecond resolution, maintenance of phase coherence over arbitrary time, large control bandwidth and dynamic range, or a combination of these and other advantages. In some instances, methods and systems presented here may allow multiplexing pulses at multiple distinct frequencies (e.g., double resonance experiments, triple resonance experiments, or higher). In some instances, methods and systems presented here may allow the elimination or reduction of filter devices and other hardware components to increase control and detection bandwidth. In some instances, methods and systems presented here can be implemented without introducing amplitude or phase droop.

In some instances, methods and systems presented here may allow maintaining single-side band (SSB) behavior during arbitrary sequences and avoid leakage of local oscillator signals. Local oscillator (LO) leakage generally refers to leakage of the LO signal to the output of the mixer device, which can cause unwanted excitation of the spin system and degrade performance of magnetic resonance system components (e.g., switches and amplifiers, etc.). In some cases, the control techniques described here can reduce LO leakage (e.g., counteract or eliminate LO leakage) without adding filters, shielding or other modifications to the spectrometer system. For instance, DC offsets can be added to digital IF signals to reduce or eliminate LO leakage.

In some instances, methods and systems presented here may allow image sideband suppression to be incorporated into digital IF signals. Image sideband suppression reduces or eliminates unwanted sidebands that would otherwise appear in a radio frequency (RF) or microwave signal due to signal conversion (e.g., mixing with an LO signal). In a mixer, LO signals are mixed with the IF signals signal to produce new frequencies, which typically include sum and difference frequencies and potentially other harmonics. One frequency range (e.g., a sideband corresponding to the sum of the mixed frequencies) typically contains the desired output signal, while unwanted image signals appear in other frequency ranges (unwanted sidebands). In some cases, the unwanted signals can interfere with operation, and so the goal is to remove signals in the unwanted sidebands using image sideband suppression. In some cases, the control techniques described here can provide image sideband suppression (e.g., reduction or elimination of unwanted sideband signals) without adding filters, shielding or other modifications to the mixer or spectrometer system. For instance, digital IF signals can be configured such that only a single sideband (containing the desired frequency range) is produced when the IF signals are converted by the mixer device (e.g., by applying phase offsets of digital IF signals); as such, unwanted sidebands can be reduced or eliminated at the digital IF stage.

In some implementations, a pulse sequence to be executed in a magnetic resonance system includes pulses and time delays. A computer system or other data processing apparatus (e.g., executing computer software or firmware) can parse the pulse sequence and construct the appropriate digital IF signal values to maintain phase coherence, single-sideband operation, and LO suppression. The computer system can also generate a hardware control sequence corresponding to the pulse sequence and store individual pulses in a memory unit (e.g., DAC memory, buffer memory, etc.) according to the pulse sequence. A superheterodyne spectrometer system can read the hardware control sequence and trigger hardware operation (e.g., digital-to-analog conversion (DAC), analog-to-digital (ADC), digital input/output (DIO), and possibly others) according to the hardware control sequence. In some implementations, a hardware control sequence allows synchronization of DACs, ADCs, and DIOs channels and enables signal averaging and other processes. A superheterodyne spectrometer system may further include a microwave or radio frequency transceiver unit that applies the pulse sequence to the spin system (e.g., via a resonator unit), and receives the resulting spin signal from the resonator unit.

Aspects of the systems and techniques described here can be adapted for various types of magnetic resonance systems. For example, computer systems, programmable controllers and other hardware components can be adapted for a nuclear magnetic resonance ("NMR") system, an electron paramagnetic resonance ("EPR") system, or another type of magnetic resonance system. As another example, systems and techniques described here may be deployed in a magnetic resonance system that includes a probe in a probe-less magnetic resonance system. In some cases, the magnetic resonance system can be adapted to operate with liquid samples, solid samples, liquid crystal samples, spin-labeled protein samples, biological samples (e.g., blood samples, urine samples, saliva samples, etc.), or other types of samples to be measured or otherwise analyzed by a magnetic resonance system. As another example, a magnetic resonance system may include components that operate in a cryogenic environment (e.g., at 77 K, 4 K, or other cryogenic temperatures below 273 K), or a magnetic resonance system may operate at non-cryogenic temperatures including room temperatures.

In some cases, the systems and techniques described here can be compatible with multiple different types of resonators, cryogenic systems, probe configurations and other components in a variety of magnetic resonance systems. For example, control techniques can be designed for compatibility with non-superconducting resonators and superconducting resonators fabricated from a variety of superconducting materials. The resonator can be, for example, a microstrip, a cavity, a coil, a waveguide, or another type of resonator for magnetic resonance systems. Additionally, the resonator could be, for example, a rectangular cavity resonator, a cylindrical cavity resonator, a dielectric resonator, a loop gap resonator, or any lumped element resonator. In some cases, the control techniques presented here can be deployed in connection with various cryogenic systems, including, for example, compact closed-cycle systems, open-cycle, liquid cryogen systems and others. In some cases, the control techniques presented here can be deployed in connection with various probes, including compact probe designs that may enable low-noise cryogenic receiver amplifiers to be used in a variety of configurations without disturbing sample changing methods. In some cases, a combination of these and potentially other advantages and improvements may be obtained.

In some cases, the techniques and system described here can be deployed in connect with continuous wave (CW) magnetic resonance (e.g., using CW ESR spectroscopy or CW NMR spectroscopy methodology), pulse magnetic resonance (e.g., using pulsed ESR spectroscopy or pulsed NMR spectroscopy methodology), or a combination of these and other MR regimes. In a typical continuous wave (CW) spectroscopy experiment, the resonator applies a low-power, continuous excitation field (e.g., a radio frequency or microwave frequency drive field) to the sample over a time period that is relatively long (e.g., relative to characteristic relaxation times) in order to bring the spin ensemble to a steady state. The resonance frequencies of the spins are swept over a range (by sweeping the principal magnetic field), and the resulting absorption spectrum is measured. In a typical pulsed spectroscopy experiment, the resonator applies a sequence of intense, high-power pulses of radiation (e.g., radio frequency or microwave pulses) to the sample, while the principal magnetic field is held constant. The resulting state of the spins can then be observed, for example, by acquiring a free induction decay (FID) or spin echo, which can then be Fourier transformed to obtain a spectrum.

Aspects of the systems and techniques described here can be adapted for various types of applications. For example, the systems and techniques described here may be used for structural biology measurements, for instance, to measure structural properties of proteins or protein complexes in a biological sample (e.g., a blood sample, a urine sample, or another type of biological sample). Such measurements can be useful in clinical applications, for example, diagnostics, treatments, pharmaceutical drug discovery/development and understanding the structure and function of membrane proteins, and other applications.

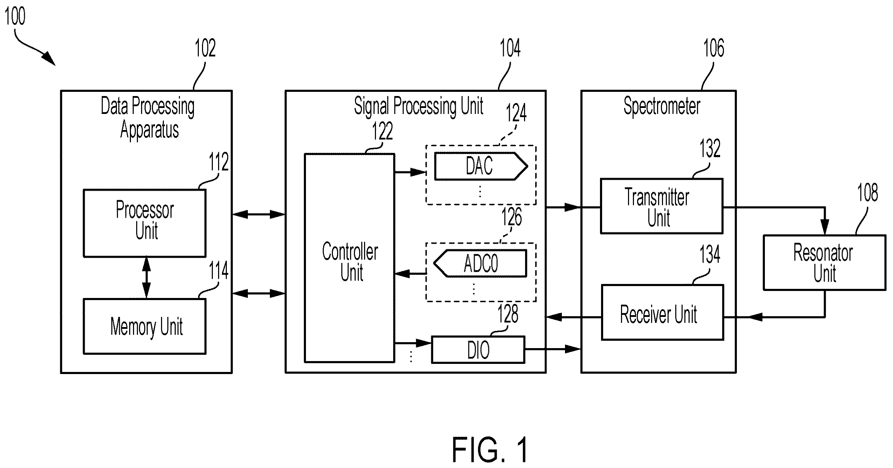

FIG. 1 is a schematic diagram showing aspects of an example magnetic resonance system 100. Generally, the example magnetic resonance system 100 can be an EPR system, an NMR system, or another type of magnetic resonance system. The example magnetic resonance system 100 includes data processing apparatus 102, a signal processing unit 104, a spectrometer 106, and a resonator unit 108. The data processing apparatus 102 includes one or more processor units 112, one or more memory units 114 and other computer elements. The signal processing unit 104 includes a controller unit 122, one or more digital-to-analog converter (DAC) devices 124, one or more analog-to-digital converter (ADC) devices 126, and a digital input/output (DIO) unit 128. The spectrometer 106 includes a transmitter unit 122 for processing a magnetic resonance control signal transmitted to the resonator unit 106 and a receiver unit 124 for processing a magnetic resonance detection signal received from the resonator unit 106. In some examples, each of the units of the magnetic resonance system 100 may include an associated electronic circuit and other components, including housing, ports, etc.

The data processing apparatus 102 may include one or more application-specific devices. The data processing apparatus 102 can be implemented as a single computer device (e.g., a laptop computer, a workstation, a desktop computer, a server) or by multiple computer devices. In some cases, the data processing apparatus 102 is co-located with the signal processing unit 104, the spectrometer 106, and resonator unit 106 in the magnetic resonance system 100; and may be directly connected to other units and components of the magnetic resonance system 100, for example, by cables (e.g., coaxial cables, network cables, waveguides, etc.) or other types of local communication channels. In some cases, all or part of the data processing apparatus 102 is located remotely from the signal processing unit 104, the spectrometer 106, and resonator unit 106, and may be directly connected to the units and components of the magnetic resonance system 100, for example, by a network (e.g., the Internet, a virtual private network, a wide area network, etc.) or other types of remote communication channels. Some aspects of the data processing apparatus 102 may be deployed in a cloud computing environment, or otherwise. In some implementations, the data processing apparatus 102 includes one or more user interfaces such as, for example, a touchscreen, a pointing device, a keyboard, a microphone, etc., that allow a user to interact with and provide input to the data processing apparatus 102. In some implementations, the data processing apparatus 102 includes one or more output devices that allow the data processing apparatus 102 to present information and data (e.g., graphical user interfaces, etc.) for display to a user.

The processor units 112 of the data processing apparatus 102 can include, for example, a central processor unit (CPU) or another type of general-purpose processor that runs software. The processor units 112 can include, for example, a graphics processing unit (GPU), a cryptographic processor unit, or other types of special-purpose co-processor units. In some instances, the processor units 112 of the data processing apparatus 102 may be configured to perform digital signal processing and signal averaging. In particular, the processor units 112 may be configured to identify a pulse sequence for a magnetic resonance experiment; generate sets of digital intermediate frequency (IF) signal information by modulating respective pulses in the pulse sequence at an intermediate frequency; generate a hardware control sequence based on the pulse sequence; communicate the digital IF signal information and the hardware control sequence to the signal processing unit 104; receive digitized magnetic resonance detection signal from the signal processing unit 104; demodulate the digitized magnetic resonance detection signal at the intermediate frequency for phase-sensitive detection; and display data. In some instances, the processor units 112 may be configured to perform other operations. For example, the processor units 112 may be configured to generate multiple resonance pulses by modulating pulses in a pulse sequence at different intermediate frequencies and superposing the modulated pulses, for example, for performing a multiple magnetic resonance measurement. In this case, the processor units 112 may be also configured to demodulate the digitized magnetic resonance detection signal at the multiple intermediate frequencies. In some instances, the processor units 112 may be controlled by software to execute a pre-configured program stored in the memory unit 114.

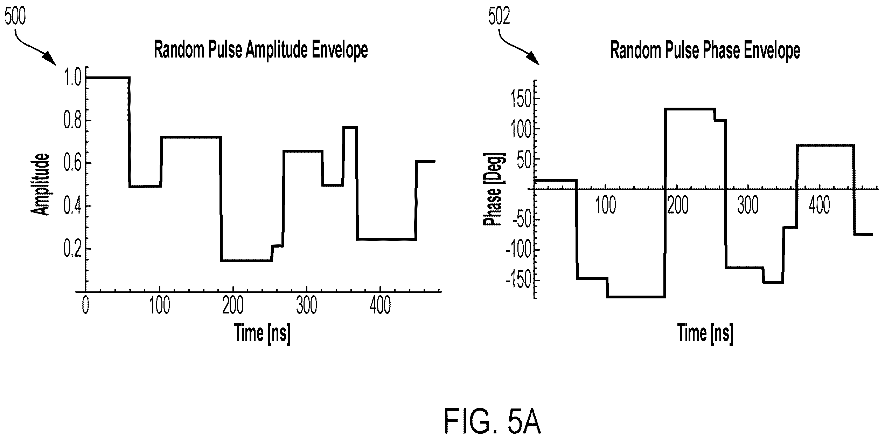

In some instances, the digital IF signal information includes digital IF signal values; one or more phase shifts based on a time series of phases specified by the pulse profile (e.g., the time series of phases 502 in FIG. 5A); and possibly other information. For example, the digital IF signal values may include a time series of I-quadrature signal values; and a time series of a Q-quadrature signal values. In some implementations, the processor units 112 are configured to modify the digital IF signal values by applying a phase shift to the time series of Q-quadrature signal values relative to the time series of I-quadrature signal values. In some implementations, the processor units 112 are configured to modify the digital IF signal values by applying DC offsets to the time series of I-quadrature signal values and the time series of Q-quadrature signal values. In some implementations, the phase shifts and the DC offsets applied to the time series of I-quadrature signal values and the time series of Q-quadrature signal values are configured to suppress an image sideband and to suppress LO leakage in a magnetic resonance control signal. In some implementations, the processor units 112 generate the digital IF signal information by performing operations 402, 404 in the example process 400, or using other types of processes.

In some instances, the memory unit 114 is used to store pre-configured programs, pulse sequence information for pulse sequences, the digital IF signal values for DAC waveform playback, hardware control sequences, digitized magnetic resonance detection signals, demodulated magnetic resonance detection signals, and other information.

In some cases, the signal processing unit 104 communicates with the data processing apparatus 102 and other units/components of the magnetic resonance system 100. The signal processing unit 104 is configured to generate analog IF electrical signals based on the digital IF signal values according to the hardware control sequence; transmit the analog IF electrical signals to the transmitter unit 122; receive magnetic resonance detection signals from the receiver unit 124; and digitizing the magnetic resonance detection signals. In some instances, the signal processing unit 104 may be configured to perform other operations.

In some implementations, the controller unit 122 of the signal processing unit 104 communicates the digital IF signal values to the DAC units 124 according to the hardware control sequence; receives the digitized magnetic resonance detection signals from the ADC units 126 according to the hardware control sequence; and generates digital control signals for hardware components in the transmitter and receiver units 132, 134 according to the hardware control sequence. In some implementations, the controller unit 122 is configured to perform operations including synchronizing output of the DAC units 124, the ADC units 126, and the DIO unit 128 to the internal timer; and controlling the output of the DAC units 124, the ADC units 126, and the DIO unit 128 according to the hardware control sequence; and other operations. The controller unit 122 is configured to synchronize phases and timing across components in the magnetic resonance system 100 according to the hardware control sequence. In some instances, the controller unit 122 may be configured to perform other operations. In some instances, the controller unit 122 of the signal processing unit 104 may include a field-programmable gate array (FPGA) unit, a digital signal processing (DSP) unit, or another type of data processing apparatus. In some instances, the signal processing unit 104 may include other signal processing devices.

The DAC unit 124 is configured to convert the digital IF signal values received from the controller unit 122 and generate analog IF electrical signals. The analog IF electrical signals generated by the signal processing unit 104 may be implemented as a pulse sequence with amplitude, phase, and frequency modulation at an intermediate frequency. In various examples, the DAC units 124 are configured to generate analog IF control signals (e.g., analog IF I-quadrature and Q-quadrature control signals) from the digital IF signal values. In the example shown, the digital control signals from the DIO unit 128 and the analog IF electrical signals from the DAC units 124 are delivered to the spectrometer 106.

The signal processing unit 104 can receive a magnetic resonance detection signal from the resonator device 106 via the receiver unit 124. The magnetic resonance detection signal includes a signal with amplitude, phase, and frequency modulation at an intermediate frequency and can be digitized by operation of the ADC units 126. The digitized magnetic resonance detection signal (e.g., spin signals) can be demodulated for further processing (e.g., for measurement, pulse transient control and correction, etc.) by operation of the processor unit 112.

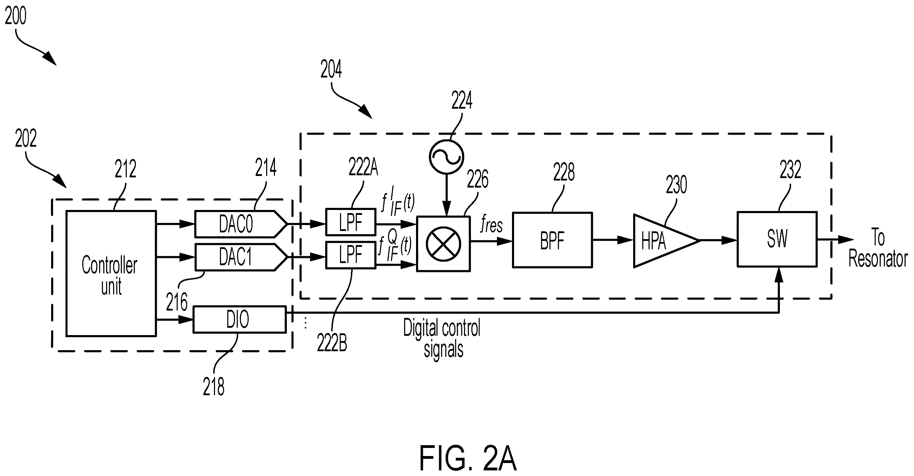

The example DIO unit 128 converts digital control toggle signals from the controller unit 122 to hardware control toggle signals (e.g., TTL, ECL, etc.) and transmits the digital control signals for the respective control components in the spectrometer 106. For example, the digital control signals can be delivered to switch devices (e.g., the switch devices 232, 252 in FIGS. 2A-2B) or other types of digitally controlled electronic components. The digital control signals from the DIO unit 128 are time-locked to an accuracy of less than 4 ns to the analog IF electrical signals generated at the DAC units 124, and the digitized magnetic resonance detection signal output from the ADC units 126.

In some instances, the transmitter unit 122 of the spectrometer 106 includes microwave or radio frequency hardware components (e.g., switches, mixers, amplifiers, attenuators, etc.) that generate and receive microwave or radio frequency signals. For instance, the transmitter unit 122 may be configured to process single sideband X-band (8 - 12 GHz) signals. In some implementations, the transmitter unit 122 includes a low phase noise microwave synthesizer to generate system master oscillator signals and analog spectrometer local oscillator signals; an IQ mixer device to upconvert analog IF electrical signals to a single sideband signal that can be applied to the resonator unit 106 and to provide local oscillator suppression and image suppression (controlled by $f_{IF}^{I}$ and $f_{IF}^{Q}$); and a bandpass filter device to suppress noise outside spectrometer bandwidth on a transmitter side. In some instances, the transmitter unit 122 may include other circuit components. In some implementations, the transmitter unit 122 can receive the analog IF electrical signals from the signal processing unit 104 and output a magnetic resonance control signal (e.g., upconverted and single band analog IF electrical signals). In some implementations, the magnetic resonance control signal has a frequency in a radio frequency or microwave regime. In the example shown in FIG. 1, the magnetic resonance control signal from the transmitter unit 122 is passed to the resonator unit 106.

In some instances, the transmitter unit 122 can be digitally controlled by the digital control signals from the signal processing unit. In some instances, the transmitter unit 122 may include one or more switch devices and a high-power amplifier (HPA) device. The transmitter unit 122 may be implemented as the transmitter unit 204 in FIG. 2A or in another manner. In some implementations, at least a portion of the transmitter unit 122 operates in an elevated temperature, e.g., room temperature, outside of a cryogenic environment. In some instances, the transmitter unit 122 operates at a cryogenic environment, for example, the same or different cryogenic environment where the resonator unit 108 resides. In some examples, the transmitter unit 122 may be digitally controlled to perform fast switching between pulses and continuous-wave modes of operation.

In some implementations, the resonator unit 106 resides in a cryogenic environment at a cryogenic temperature, for example, in a cryostat. The resonator unit 106 includes a resonator that generates electromagnetic fields (e.g., drive fields) in a sample region of the magnetic resonance system. The resonator unit 106 may include signal wirings for communicating microwave signals and digital control signals, cryogenic receiver components, and internal hardware for temperature setting and stabilization. In some instances, the data processing apparatus 102 may also communicate control signals to the resonator unit 106.

In some instances, the receiver unit 124 includes an amplifier device (e.g., a cryogenic LNA device). In some implementations, the receiver unit 124 includes a mixer device for down-converting magnetic resonance detection signals received from the resonator device 106 to an intermediate frequency ($f_{IF}$), by mixing the magnetic resonance detection signals with a local oscillator frequency ($f_{LO}$). The receiver unit 124 may also include a filter device that removes unwanted frequency components, for example, a bandpass IF filter device that rejects frequencies near a frequency value of $f_{LO} - f_{IF}$ from the mixer device and suppresses noise outside the receiver bandwidth ($\pm f_{IF}$). The receiver unit 124 may also include other components such as, for example, an IF amplifier device, a lowpass filter device, and other circuit components. In some instances, the receiver unit 124 includes various stages of filtering and amplification to reduce noise bandwidth. The example receiver unit 124 shown in FIG. 1 can accept both low-level spin signal inputs and high-level pulse transient digitizing inputs. In some examples, the receiver unit 124 may be controlled to switch between modes of operation, for example, between a magnetic resonance measurement mode and a pulse transient digitizing/correcting mode.

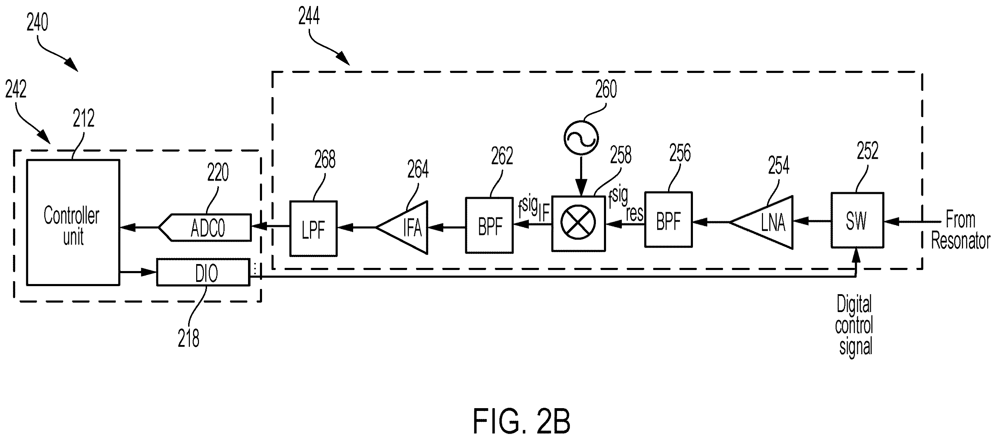

In some instances, the spectrometer 104 may be configured to process single-sideband Ku-band signals (12-18 GHz), Q-band signals (33-50 GHz), W-band signals (75-110 GHz, or signals in other microwave frequency bands. For example, the transmitter unit 122 and the receiver unit 124 may include a single stage of up-conversion (e.g., FIG. 2A) or down-conversion (e.g., as shown in FIG. 2B) with a single microwave synthesizer device that is configured to generate LO signal at a respective microwave frequency band. For another example, the transmitter unit 122 and the receiver unit 124 may include two or more stages of up-conversion or down-conversion with two or more microwave synthesizer devices and two or more corresponding mixer devices.

In the example shown in FIG. 1, components of the spectrometer 106 are electromagnetically coupled to (e.g., by coaxial cables, waveguides, etc.), and adapted to communicate with the resonator unit 106. For example, the transmitter unit 122 can be adapted to provide a voltage or current electrical signal that drives the resonator unit 106. In the example shown in FIG. 1, the receiver unit 124 acquires magnetic resonance data based on control signals delivered to the resonator device 106. For example, the receiver unit 124 may receive magnetic resonance detection signals generated by an interaction between the resonator unit 106 and samples contained in the resonator unit 106 based on the magnetic resonance control signals received at the resonator unit 106.

In some implementations, the magnetic resonance system 100 includes a superheterodyne spectrometer system. Generally, a superheterodyne spectrometer generates magnetic resonance control signals by mixing intermediate frequency (IF) signals with local oscillator (LO) signals to produce a high frequency (e.g., RF or microwave) signal that can then be further processed and passed on to the resonator unit 106; a superheterodyne spectrometer processes high-frequency magnetic resonance detection signals (e.g., spin signals) from the resonator unit 106 by mixing the high-frequency signals with LO signals to produce an IF signal, which can then be further processed and digitized for analysis by the data processing apparatus 102. Superheterodyne operation can allow for increased sensitivity, selectivity, and signal-to-noise ratio, among other advantages. By generating control information and processing detected signals at IF frequencies, superior control and data processing can be achieved in some cases. Also, by using one or more tunable local oscillators, the superheterodyne spectrometer can tune to multiple distinct spin resonance frequencies, making it a versatile system.

In some examples, the example magnetic resonance system 100 may include additional or different components, and the components may be arranged as shown or in another manner. For example, the example magnetic resonance system 100 may include a temperature control unit (TCU) configured and operated to monitor and stabilize the temperature of the cryogenic environment where the resonator unit 106 resides; a field control unit (FCU) configured and operated to monitor, stabilize, and vary a primary magnetic field in the magnetic resonance system 100; an electromagnet power supply and a Hall probe which interface with the FCU to receive control signals from the FCU and apply appropriate current to the primary magnet system. In some instances, the example magnetic resonance system 100 includes a cryostat cooled by Helium or Nitrogen which can be maintained at a cryogenic temperature (e.g., equal to or less than 1 K or another cryogenic temperature). In some instances, a cryostat of the example magnetic resonance system 100 includes internal control hardware for temperature setting and stabilization.

In some aspects of operation, a primary magnet system in the magnetic resonance system 100 generates a primary magnetic field in a controlled environment of a sample region in the magnetic resonance system 100. The primary magnetic field is applied to a sample in a sample region that is typically near the resonator device 106. In various implementations, the primary magnetic field can be homogeneous over the volume of the sample region. In some instances, a gradient system generates one or more gradient fields that spatially vary over the sample region. Generally, the primary magnetic field generated by the primary magnet system quantizes the spin states and sets the Larmor frequency of the spin ensemble.

In some aspects of operation, a spin ensemble in the sample interacts with the resonator device 106. Control of spins in the sample can be achieved, for example, by a radiofrequency or microwave magnetic field generated by the resonator device. The drive frequency can be tuned to the spins' resonance frequency, which is determined by the strength of the primary magnetic field and the gyromagnetic ratio of the spins. The spins can be a collection of particles having non-zero spin that interact magnetically with the applied fields. For example, the spin ensemble can include nuclear spins, electron spins, or a combination of nuclear and electron spins. Examples of nuclear spins include hydrogen nuclei (1H), carbon-13 nuclei (13C), and others. In some implementations, the spin ensemble is a collection of identical spin -1/2 free electron spins attached to an ensemble of large molecules.

FIG. 2A is a schematic diagram showing aspects of an example magnetic resonance system 200. The components of the example magnetic resonance system 200 shown in FIG. 2A are configured to generate and deliver a magnetic resonance control signal to a resonator device. As shown in FIG. 2A, the example magnetic resonance system 200 includes a signal processing unit 202 and a transmitter unit 204. In some instances, the signal processing unit 202 and the transmitter unit 204 may be implemented as the controller unit 122 and the transmitter unit 122, respectively, in the example magnetic resonance system 100 in FIG. 1, or in another manner. In some examples, the example magnetic resonance system 200 may include additional or different components, and the components may be arranged as shown or in another manner.

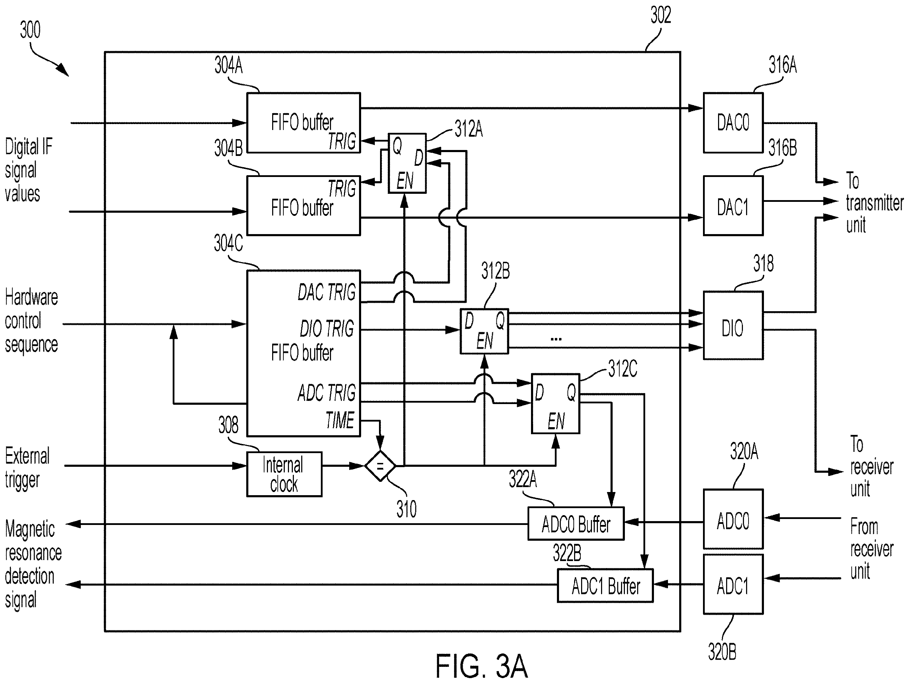

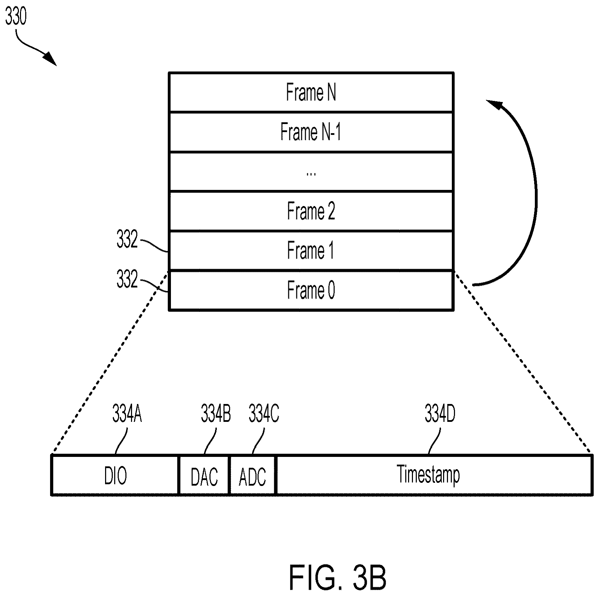

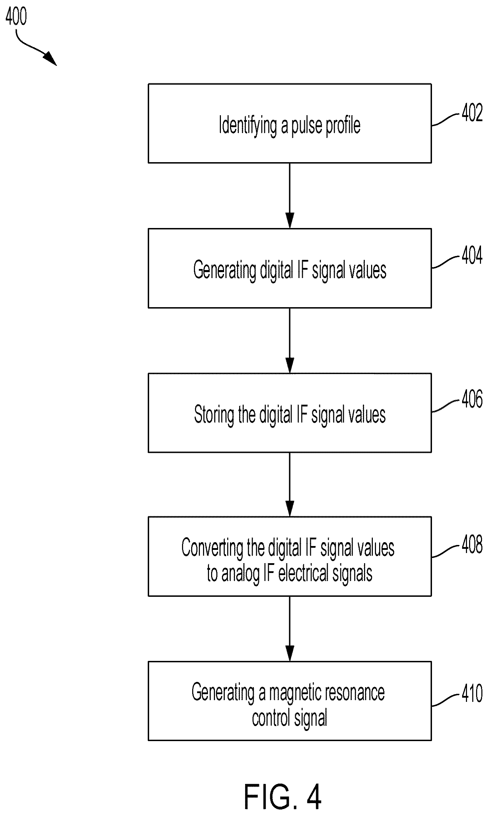

As shown in FIG. 2A, the signal processing unit 202 includes a controller unit 212, two DAC units 214, 216, and a DIO unit 218. In some instances, the controller unit 212 may be a field-programmable gate array (FPGA) module, which may include one or more buffer devices, digital signal processing devices, and other electronic devices. In some implementations, the controller unit 212 is configured to send digital intermediate frequency (IF) signal values to a first DAC unit 214 and a second DAC unit 216; and to control the DIO devices 218 to send digital control signals according to a hardware control sequence. In some implementations, the controller unit 212 is configured to receive and store the digital IF signal values depicting a digital IF signal, and the hardware control sequence for scheduling and synchronizing output signals of the first and second DAC units 214, 216, and the DIO device 218 in time to maintain phase coherence. In some instances, the signal processing unit 202 may be implemented as the signal processing unit 300 in FIG. 3 or in another manner. In some implementations, the signal processing unit 202 is configured to perform operations in the example process 400 in FIG. 4.

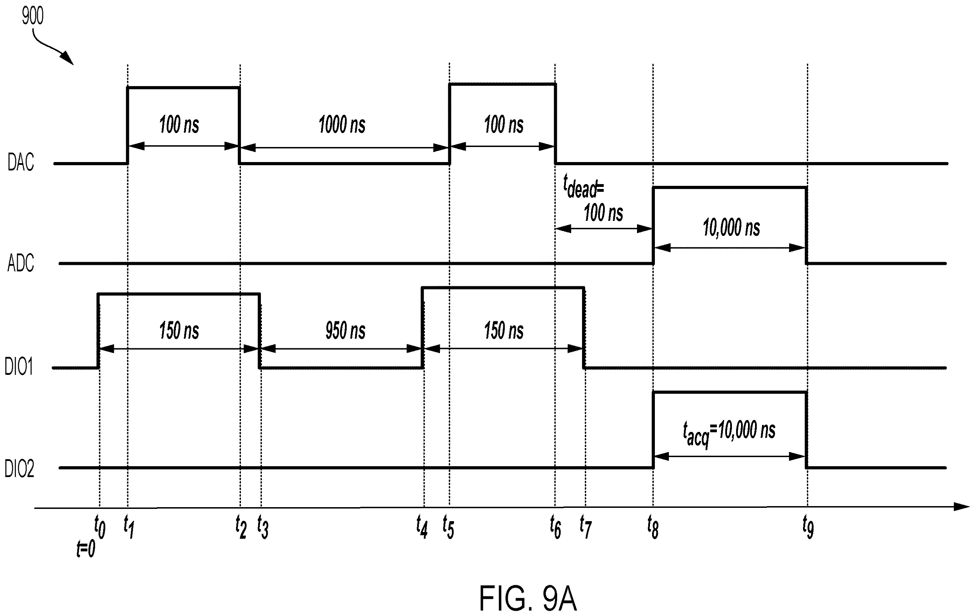

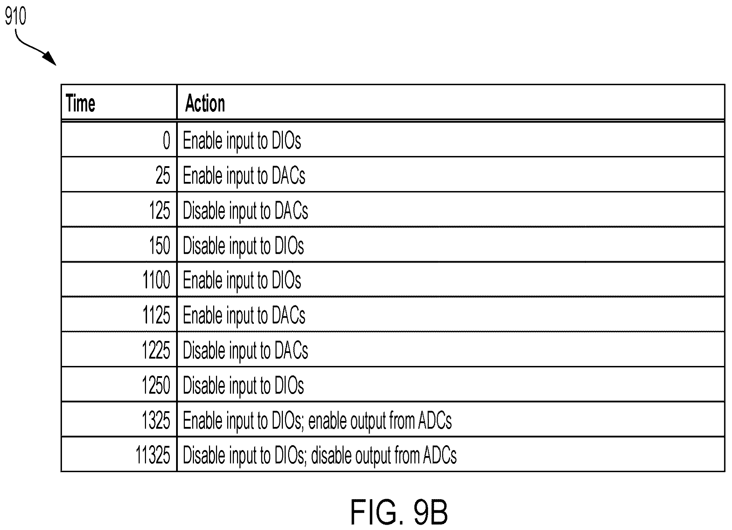

In some implementations, the first DAC unit 214 is configured to receive a first set of digital IF signal values (e.g.,

digital I-quadrature signal values) according to the hardware control sequence (e.g., the example hardware control sequence shown in FIGS. 9A-9B) from the controller unit 212; generate a first analog IF electrical signal (e.g., an I-quadrature control signal); and send the first analog IF electrical signal to a first input port of the transmitter unit 204. Similarly, the second DAC unit 216 is configured to receive a second set of digital IF signal values (e.g., digital Q-quadrature signal values) according to the hardware control sequence from the controller unit 212; generate a second analog IF electrical signal (e.g., a Q-quadrature control signal); and send the second analog IF electrical signal to a second input port of the transmitter unit 204. The DIO device 218 is configured to receive digital control signal values from the controller unit 212; and send the digital control signal values to the transmitter unit 204 (e.g., the switch device 232 of the transmitter unit 204 or other digitally controlled devices). In some implementations, the digital control signals are phase locked to the first and second analog IF electrical signals from the first and second DAC units 214, 216. The transmitter unit 204 includes a superheterodyne spectrometer that mixes the first and second analog IF electrical signals with local oscillator (LO) electrical signals and generates and processes the magnetic resonance control signal.

As shown in FIG. 2A, the transmitter unit 204 includes low-pass filter devices 222A, 222B, a microwave synthesizer device 224, a mixer device 226, a bandpass filter device 228, a high-power amplifier (HPA) device 230, and a switch device 232. In some instances, the transmitter unit 204 may include additional microwave hardware components (e.g., switches, mixers, amplifiers, attenuators, etc.) for generating and receiving single sideband X-band (8 - 12 GHz) signals; and the components of the transmitter unit 204 may be arranged in a different order.

As shown in FIG. 2A, each of the low-pass filter devices 222A, 222B has an input port connected to the input port of the transmitter unit 204 and an output port connected to an input port of the mixer device 226. In some implementations, the input ports of the transmitter unit 204 can receive the first and second analog IF electrical signals from the DAC units 214, 216 of the signal processing unit 202; and an output port of the transmitter unit can provide magnetic resonance control signals for transmission to a resonator device. The resonator device receives the magnetic resonance control signals and generates a control field (e.g., a drive field) in response to the received magnetic resonance control signal. In some instances, the magnetic resonance control signal is upconverted based on the analog IF electrical signals and the LO electrical signal.

The mixer device 226 includes a third input port which is connected to the local oscillator device 224 for receiving local oscillator electrical signals. The input port of the bandpass filter device 228 is coupled to the output port of the mixer device 226. The HPA device 230 includes an HPA input port and an HPA output port. The HPA input port is coupled to the output of the bandpass filter device 228. The input port of the switch device 232 is coupled to the HPA output port of the HPA device 230. The output port of the switch device 232 is coupled to the output port of the transmitter unit 204. In some implementations, the input and output ports of the components in the transmitter unit 204 are connected to one another through waveguides, co-axial cables, metal wires or feedlines, or another type of signal lines.

In some instances, each of the low-pass filter devices 222A, 222B is an anti-aliasing low-pass filter device having a cutoff frequency of $2f_{IF}$. In some instances, the low-pass filter device 222A, 222B may be another type of low-pass filter device having a cutoff frequency of another value. The filtered first analog IF electrical signal at the first input port of the mixer device 226 is a digitally generated analog IF I-quadrature control signal with amplitude, phase, and frequency modulation. In some cases, the first analog IF electrical $f_{IF}^I(t)$ includes control pulses and can be described as

$$f_{IF}^I(t) = A_0^1 + A(t)\sin\big[\big(\omega_{IF} + \omega(t)\big)t + \phi_0^1 + \phi(t)\big] \qquad (1)$$

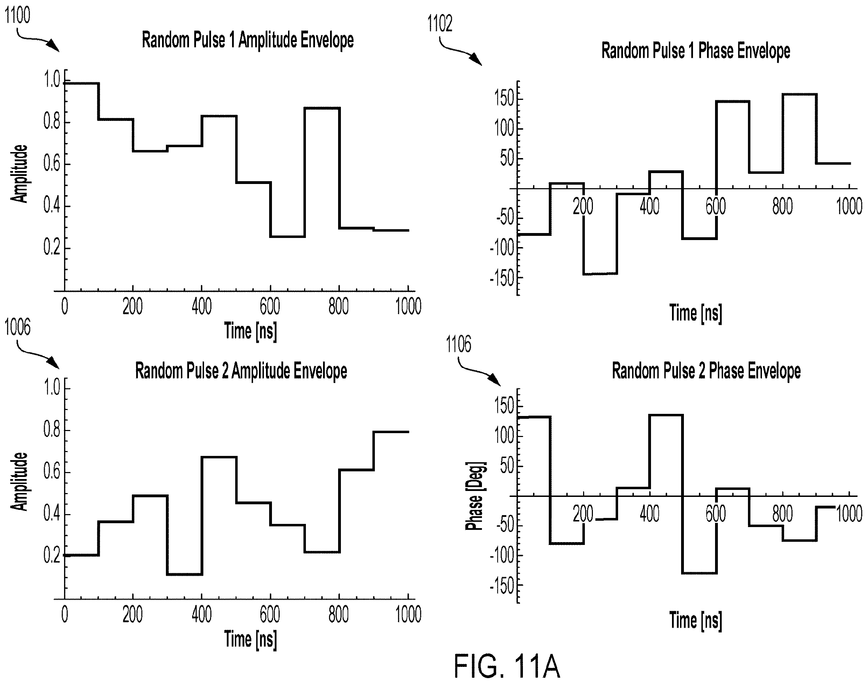

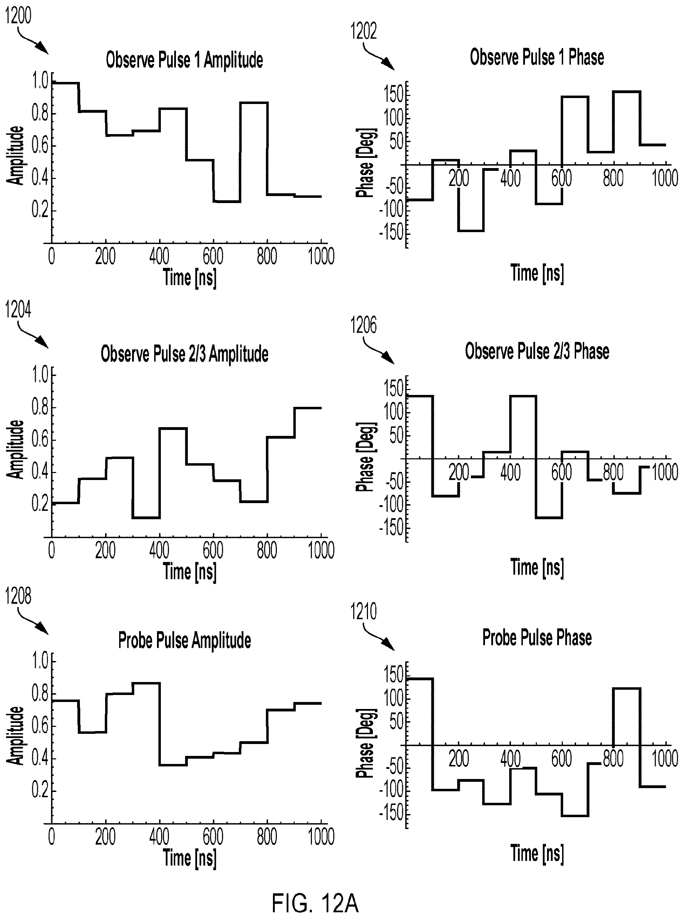

where $A_0^1$ is adjustable constant DC amplitude for LO suppression at the output port of the mixer device 226; $\phi_0^1$ is adjustable constant phase offset which can be adjusted and tuned for image suppression at the output of the mixer device 226; $\omega_{IF}$ is a user-variable intermediate frequency; and $A(t)$, $\omega(t)$, and $\phi(t)$ characterize amplitude modulation, frequency modulation, and phase modulation, respectively. In some instances, $\omega_{IF}$ can be changed within an experiment (e.g., FIGS. 11A-11C and 12A-12C). In some examples, the $\omega_{IF}$ is in a range of 0 (e.g., DC) to half of the sampling frequency of the DACs, or in another range.

In some implementations, the filtered second analog IF electrical signal at the second input port of the mixer device 226 is a digitally generated analog IF Q-quadrature control signal $f_{IF}^Q(t)$ with amplitude, phase, and frequency modulation. In some cases, the second analog IF electrical signal $f_{IF}^Q(t)$ includes control pulses and can be described as

$$f_{IF}^Q(t) = A_0^2 + A(t)\cos\big[\big(\omega_{IF} + \omega(t)\big)t + \phi_0^2 + \phi(t)\big] \qquad (2)$$

where $A_0^2$ is adjustable constant DC amplitude for LO suppression and removing LO leakage at the output port of the mixer device 226; $\phi_0^2$ is adjustable constant phase offset for image suppression at the output port of the mixer device 226; and $A(t)$, $\omega(t)$, and $\phi(t)$ characterize amplitude modulation, frequency modulation, and phase modulation, respectively.

In some examples, the microwave synthesizer device 224 is a low phase-noise microwave synthesizer device configured to generate system master oscillator signals and analog spectrometer local oscillator signals. In some instances, the microwave synthesizer device 224 may be another type of microwave synthesizer device. In some instances, the mixer device 226 is an IQ mixer device configured to receive the filtered first and second analog IF electrical signals; upconvert the filtered first and second analog IF electrical signals to a magnetic resonance control signal (e.g., a single sideband signal, $f_{res}$) to be resonant with spins in the resonator device; provide LO suppression and image suppression (controlled by $f_{IF}^I$ and $f_{IF}^Q$); and communicate the magnetic resonance control signals to the resonator device.

In some examples, the bandpass filter device 228 of the transmitter unit 204 is configured to suppress noise outside spectrometer bandwidth and from other circuit components without reducing pulse bandwidth. In some implementations, the bandpass filter device 228 has a center frequency at $f_0 + f_{IF}$, where $f_0$ is the resonator frequency (e.g., 8-12 GHz for X-band, 12-18 GHz for Ku-band, 33-50 GHz, and 75-110 GHz for W-band) and $f_{IF}$ is the intermediate frequency, and a bandwidth of $4f_{IF}$. In some instances, the bandpass filter device 228 has a center frequency and bandwidth of different values. In some instances, the HPA device 230 is configured to amplify the magnetic resonance control signal before sending it to the resonator device. In some implementations, magnetic resonance control signals transmitted to the resonator devices include a sequence of analog control pulses with frequencies in a microwave regime. In some implementations, the transmitter unit 204 may include other microwave hardware components (e.g., switches, mixers, amplifiers, attenuators, etc.) necessary for generating and receiving single sideband signals.

In some implementations, the switch device 232 of the transmitter unit 204 includes a control port for receiving a digital control signal from the DIO device 218 of the signal processing unit 202; and is digitally controlled to perform fast blanking of the magnetic resonance control signal to the resonator device. In some instances, the transmitter unit 106 may include additional or different switch devices, filter devices, and other devices. In some implementations, the signal processing unit 202 and at least part of the transmitter unit 204 operate at an elevated temperature, e.g., room temperature, outside of a cryogenic environment where the resonator device resides in some cases. In some implementations, the transmitter unit 204 operates at a cryogenic temperature.

In some implementations, the digital control signal generated by the signal processing unit 202 and received at the switch device 232 of the transmitter unit 204 may be a transistor-transistor logic (TTL) signal with two TTL logic levels. When the TTL signal is at a voltage in a range of 1.5-5 volt (V), the TTL logic level is a digital "1" or at a logical high level; and similarly, when the TTL signal is at a voltage in a range of 0-0.7 V, the TTL logic level is a digital "0" or at a logical low level. In some instances, the TTL logic level may be in another range; and the digital control signal is another type of digital signal. In some instances, the digital control signal received at the switch device 232 may be another type of digital control signal.

In some implementations, input and output ports of switch devices may be selectively coupled or decoupled according to a state of a digital control signal. The input port of a switch device may be considered coupled to an output port of the switch device when the switch devices is configured to deliver a signal from the input port to the output port with no attenuation or negligible attenuation. Similarly, the input port of a switch device may be considered decoupled from an output port of the switch device when the switch devices is configured to provide negligible transmission of a signal from the input port to the output port of the switch device; for instance, the switch device may completely block the signal or substantially attenuate the signal (e.g., with an attenuation level equal to or greater than a threshold value).

In some implementations, the switch device 232 is configured to switch between a first state and a second state in response to a change in a state of the digital control signal at the control port. When the digital control signal received at the switch device 232 is in the first state (e.g., the logic high level), the switch device 232 is switched to the first state for coupling the input port to the output port of the switch device 232, which allows delivering the magnetic resonance control signal to the output port of the switch device 232 with no attenuation or negligible attenuation. When the digital control signal received at the switch device 232 is in the second state (e.g., the logic low level), the switch device 232 is in the second state for decoupling the input port from the output port of the switch device 232, which blocks the magnetic resonance control signal with significant attenuation.

In some implementations, the switch device 232 is a single-pole, single-throw switch device. In some instances, the switch devices 232 may be another type of switch device. For example, the switch devices 232 may have any number of poles, any number of throws, any number of input ports, output ports, and control ports. In some instances, the switch device 232 may include more than two states. In some instances, the control port of the switch devices 232 may interface with one-bit control line, two-bit control line, or other multi-bit control line for receiving respective types of digital control signals.

In some implementations, the first and second analog IF electrical signals at the first and second input ports of the transmitter unit 204 and the digital control signal at the switch device 232 are synchronized by a hardware control sequence (e.g., the example hardware control sequence 900, 910 in FIGS. 9A-9B). As an example, during a continuous-wave magnetic resonance measurement or a pulsed magnetic resonance measurement, when the first and second analog IF electrical signals are received at the first and second input ports of the transmitter unit 204 during time periods $t_2 - t_1$, and $t_6 - t_5$, the switch device 232 is in the first state during the same time periods as defined in the hardware control sequence in FIGS. 9A-9B. In some implementations, when the first and second analog IF electrical signals are not received at the first and second input ports of the transmitter unit 204, e.g., during time periods $t_4 - t_3$, and $t_8 - t_7$, the switch device 232 is in the second state during the same time periods as defined in the hardware control sequence in FIGS. 9A-9B. In some instances, the switch device 232 is switched to the first state at time $t_0$ prior to enabling a DAC waveform playback at time $t_1$; and switched to the second state at time $t_3$ after disabling the DAC waveform playback at time $t_2$.

In some implementations, the switch time of the switch device 232 is in a range of 5-20 ns, equal to or less than 200 ns, equal to or less than 1 $\mu$s, or in another range. In some implementations, the switch device 232 can receive and handle an input signal with a power up to 1 W, or in another range. In some instances, the switch device 232 can be configured to handle higher power, for an example, in a range of more than 1 watt (W); up to tens of Watts, up to 10 kilowatts (kW), or another range according to the HPA device 230.

A pulse sequence can include a series of pulses and delays; for instance, a pulse sequence may include a first pulse, a time delay after the first pulse and a second pulse after the time delay. The data processing apparatus 102 is configured to identify a first pulse profile for the first pulse; generating first digital IF signal values based on the first pulse profile; and generate first analog IF electrical signals based on the first digital IF signal values. By operation of the transmitter unit 122, the first analog IF electrical signals is mixed with local oscillator electrical signals to produce a first magnetic resonance control signal, which is delivered to the resonator unit 106 of the magnetic resonance system 100. The data processing apparatus 102 is further configured to identify a second pulse profile; generate second digital IF signal values based on the second pulse profile; implement the time delay; generate a second analog IF electrical signal based on the second digital IF signal values. By operation of the transmitter unit 122, the second analog IF electrical signals are mixed with local oscillator electrical signals to produce a second magnetic resonance control signal, which is delivered to the resonator unit 106 of the magnetic resonance system 100.

FIG. 2B is a schematic diagram showing aspects of an example magnetic resonance system 240. The example components of the magnetic resonance system 240 shown in FIG. 2B are configured to receive a magnetic resonance detection signal from a resonator unit. As shown in FIG. 2B, the example magnetic resonance system 240 includes a signal processing unit 242 and a receiver unit 244. In some implementations, the signal processing unit 242 and at least a portion of the receiver unit 244 operate at an elevated temperature, e.g., room temperature, outside of a cryogenic environment where the resonator unit resides in some cases. In some instances, certain devices or components of the receiver unit 244 may reside in a cryogenic environment with the resonator unit or in a distinct cryogenic environment at a distinct cryogenic temperature. In some instances, the signal processing unit 242 and the receiver unit 244 may be implemented as the controller unit 122 and the receiver unit 124 in the example magnetic resonance system 100 in FIG. 1 or in another manner. In some examples, the example magnetic resonance system 240 may include additional or different components, and the components may be arranged as shown or in another manner.

As shown in FIG. 2B, the signal processing unit 242 includes the controller unit 212, an ADC unit 220, and the DIO devices 218. In some instances, the signal processing unit 242 may be implemented as the signal processing unit 202 in FIG. 2A. In some implementations, the controller unit 212 is configured to receive a digitized magnetic resonance detection signal from the ADC unit 220; and to operate the DIO devices 218 to send digital control signals. Acquisition of the magnetic resonance detection signal from the resonator unit can be controlled by the controller unit 212. In some implementations, the receiver unit 244 is adapted to down-convert the magnetic resonance detection signal to an intermediate frequency. In some implementations, the acquired magnetic resonance detection signal can be digitized phase-coherently at the intermediate frequency by operation of the ADC unit 220. In some implementations, the acquisition of the digitized magnetic resonance detection signal is synchronized with the digital control signals (e.g., the digital control signal applied to the switch device 252) according to a hardware control sequence (e.g., the example hardware control sequence shown in FIGS. 9A-9B). By operation of a processor unit (e.g., the processor units 112 of the data processing apparatus 102 in FIG. 1), the digitized magnetic resonance detection signal can be digitally demodulated at the intermediate frequency for phase-sensitive detection. In some implementations, the digital control signals are phase locked to the output signals of the ADC unit 220. In some instances, by operation of the processor unit, accurate and arbitrary phase corrections may be applied to the demodulated digitized magnetic resonance detection signal. When a multiple resonance magnetic resonance measurement is performed, the digitized magnetic resonance detection signal may be demodulated, by operation of the processor units, using multiple IF carrier signals with different intermediate frequencies and processing the demodulated digitized magnetic resonance detection signals in parallel.

As shown in FIG. 2B, the receiver unit 244 includes a switch device 252, a low-noise amplifier (LNA) device 254, a first bandpass filter device 256, a mixer device 258, a microwave synthesizer device 260, a second bandpass filter device 262, an intermediate frequency amplifier (IFA) device 264, and a low-pass filter device 268. In some instances, the receiver unit 244 may include additional microwave hardware components (e.g., switches, mixers, amplifiers, attenuators, etc.) for processing the magnetic resonance detection signals; and the components of the receiver unit 244 may be arranged in a different manner. In some instances, the receiver unit 244 includes various stages of filtering and amplification to reduce noise bandwidth. In some implementations, the magnetic resonance detection signal received at an input port of the receiver unit 244 includes low-level spin signal inputs, high-level pulse transient digitizing inputs, or other types of signals.

As shown in FIG. 2B, the switch device 252 has an input port connected to the resonator device and an output port connected to an LNA input port of the LNA device 254. In some implementations, the input port of the switch device 252 can receive the magnetic resonance detection signals from the resonator unit. An input port of the first bandpass filter device 256 is connected to an LNA output port of the LNA device 254. A first input port of the mixer device 258 is connected to an output port of the first bandpass filter device 256; and a second input port of the mixer device 258 is connected to the microwave synthesizer 260 for receiving local oscillator electrical signals. An input port of the second bandpass filter device 262 is connected to an output port of the mixer device 258. An input port of the IFA device 264 is connected to an output port of the second bandpass filter device 262. An input port of the low-pass filter device 268 is connected to an output port of the IFA device 264. An output port of the low-pass filter device 268 is connected to an input port of the ADC unit 220 of the signal processing unit 242. In some implementations, the input and output ports of the components in the receiver unit 244 are connected to one another through waveguides, co-axial cables, or another type of signal lines.

As shown in FIG. 2B, the switch device 252 of the receiver unit 244 includes a control port for receiving a digital control signal from the DIO unit 218 of the signal processing unit 242; and is digitally controlled to perform fast blanking of the receiver unit 244 during application of high-power pulses. For example, during the time periods $t_2 - t_1$, and $t_6 - t_5$ as shown in FIGS. 9A-9B, the digital control signal communicated to the switch device 252 is at an "off" state for receiver blanking; and during the time periods $t_9 - t_8$, the digital control signal communicated to the switch device 252 is at an "on" state for signal acquisition. The LNA device 254 is operated at low power (e.g., less than 1 W or another value) and has a high gain (e.g., 30-50 dB or in another range). The first bandpass filter device 256 is a narrowband filter with a center frequency around the resonator frequency ($f_0$) for noise rejection and a bandwidth larger than the resonator bandwidth. The microwave synthesizer device 260 is a low phase-noise microwave synthesizer device configured to generate system master oscillator signals and analog spectrometer local oscillator electrical signals. In some instances, the microwave synthesizer 260 may be implemented similar to the microwave synthesizer device 224 in the transmitter unit 204 in FIG. 2A or in another manner. In some instances, the mixer device 258 is an IQ mixer device and is configured to receive the magnetic resonance detection signal; down-convert the frequency of the magnetic resonance detection signal to the intermediate frequency ($f_{IF}$); and transmit the down-converted magnetic resonance detection signal to the second bandpass filter device 262. The second bandpass filter device 262 is a narrowband filter device with a center frequency around the intermediate frequency ($f_{IF}$) for rejection of $f_{IF} + f_{LO}$ signal from the mixer device 258 and suppressing noise outside receiver bandwidth ($\pm f_{IF}$). The intermediate frequency amplifier (IFA) device 264 is configured to amplify the down-converted magnetic resonance detection signal before sending it to the signal processing unit 242. In some instances, the IFA device 264 may include one single amplifier device or may include a chain of amplifier devices to increase gain. The low-pass filter device 268 is an anti-aliasing filter having a cutoff frequency of $< 2f_{IF}$ for the ADC unit 220.

In some implementations, the digital control signal generated by the signal processing unit 242 and received at the switch device 252 of the receiver unit 244 may be a transistor-transistor logic (TTL) signal with two TTL logic levels. When the TTL signal is at a voltage in a range of 1.5-5 volt (V), the TTL logic level is a digital "1" or at a logical high level; and similarly, when the TTL signal is at a voltage in a range of 0-0.7 V, the TTL logic level is a digital "0" or at a logical low level. In some instances, the TTL logic level may be in another range; and the digital control signal is another type of digital signal.

In some implementations, the switch device 252 is configured to switch between a first state and a second state in response to a change in a state of the digital control signal at the control port. When the digital control signal received at the switch device 252 is in the first state (e.g., the logic high level), the switch device 252 is in the first state for coupling the input port with the output port of the switch device 252, which allows delivering the magnetic resonance detection signal from the input port to the output port of the switch device 252 with no attenuation or negligible attenuation. When the digital control signal received at the switch device 252 is in the second state (e.g., the logic low level), the switch device 252 is in the second state where the input port is decoupled from the output port of the switch device 252 blocking the magnetic resonance detection signal with significant attenuation.

In some implementations, the switch device 252 is a single-pole, single-throw switch device. In some instances, the switch devices 252 may be another type of switch device. For example, the switch devices 252 may have any number of poles, any number of throws, any number of input ports, output ports, and control ports. In some instances, the switch device 252 may include more than two states. In some instances, the control port of the switch devices 252 may interface with one-bit control line, two-bit control line, or other multi-bit control line for receiving respective types of digital control signals.

In some implementations, the switch time of the switch device 252 is in a range of 5-20 ns, equal to or less than 200 ns, equal to or less than 1 μs, or in another range. In some implementations, the switch device 252 can receive and handle an input signal with a power up to 1 W, or in another range. In some instances, the switch device 252 can be configured to handle higher power, for an example, in a range of more than 1 W; up to tens of Watts, up to 10 kilowatts (kW), or another range according to the LNA device 254.

In some implementations, the digital control signal from the DIO unit 218 to the switch device 252 and the output of the ADC unit 220 are synchronized. For example, as specified in the example hardware control sequence in FIGS. 9A-9B, at time step $t_8$, the switch device 252 is switched from the second state to the first state; during time periods $t_9$ - $t_8$, the switch device 252 remains in the first state to communicate the digitized magnetic resonance detection signal (e.g., to the processor unit 112 in FIG. 1); and at time step $t_9$, the switch device 252 is switched from the first state to the second state.

FIG. 3A is a schematic diagram of an example signal processing unit 300 of a magnetic resonance system. The signal processing unit 300 may include a controller unit 302, two DAC units 316A, 316B, two ADC units 320A, 320B, and a DIO unit 318. In some instances, the example signal processing unit 300 may be implemented as the controller unit 104, 202, 242 in FIGS. 1, 2A-2B or in another manner. In some instances, the DAC units 316A, 316B, the ADC units 320A, 320B, and the DIO unit 318 may be implemented as described with respect to FIGS. 2A-2B or in another manner. In some examples, the example signal processing unit 300 may include additional or different components, and the components may be arranged as shown or in another manner.

The example signal processing unit 300 includes first-in-first-out (FIFO) buffer devices 304A, 304B, 304C. In some instances, the FIFO buffer devices 304A, 304B, 304C are configured to buffer data before sending it to the respective devices, e.g., the DAC units 316A, 316B, the DIO devices 318, and other devices, according to a hardware control sequence. In the example shown, the FIFO buffer device 304A is configured to buffer digital IF signal values for generating the analog IF I-quadrature signal; the FIFO buffer device 304B is configured to buffer digital IF signal values for generating the analog IF Q-quadrature signal; and the FIFO buffer device 304C is configured to buffer the hardware control signal, which includes timestamp values and hardware control values. In some instances, the FIFO buffer device 304C may be a circular FIFO buffer device, which can recycle and reuse commands stored in the buffer device. The digital IF signal values and the hardware control sequence are determined by one or more processor units of a computer system (e.g., the processor units 112 of the data processing apparatus 102) based on a target pulse sequence; and are configured to construct a magnetic resonance control signal for the resonator unit. In some instances, the FIFO buffer devices 304A, 304B, 304C may be configured to perform other functions. In some implementations, operations of the FIFO buffer devices 304A, 304B, 304C are based on a timer compare value determined by comparing a current time value based on a clock signal produced by an internal clock 308 and the timestamp values in the hardware control sequence. In some instances, the clock signal produced by the internal clock 308 can be effectively delayed at a firmware level for each respective hardware components to ensure sub-ns synchronization of all the outputs of the DAC units, ADC units, and the DIO unit. In some cases, the clock signal is delayed by setting a timestamp value to a later time. For example, by configuring the timestamp value of the timestamp section 334D in a frame 332 to a later time, the respective trigger enable units 312A, 312B, 312C may be enabled at the later time, which then enable communications of the DAC trigger values, the ADC trigger values, and the DIO trigger values to the DAC units, ADC units, and the DIO unit so that the operations of the respective devices are synchronized at the later time. In some instances, each of the FIFO buffer devices 304A, 304B, 304C may include registers, block random access memory (BRAM), or other types of memory devices which may be defined by a width and a depth.

In some instances, data (e.g., the digital IF signal values and the hardware control sequence) can be written in the respective FIFO buffer devices 304A, 304B, 304C during a write cycle and read out from the respective FIFO devices 304A, 304B, 304C during a read cycle. In the example shown, the digital IF signal values are received at the controller unit 302 of the signal processing unit 300. The digital IF signal values corresponding to the analog IF I-quadrature signal and the digital IF signal values corresponding to the analog IF Q-quadrature signal are obtained and separately stored in the respective FIFO buffer device 304A, 304B. Similarly, the hardware control sequence is received at the controller unit 302 and stored in the FIFO buffer device 304C. Reading of the digital IF signal values stored in the FIFO devices 304A, 304B is performed according to a hardware control sequence stored in the FIFO device 304C. In some instances, the hardware control sequence may be implemented as the example hardware control sequence 900, 910 shown in FIGS. 9A-9B; and has an example data format shown in FIG. 3B or in another format.

As shown in FIG. 3A, the FIFO buffer device 304C includes an input port for receiving the hardware control sequence and output ports for communicating the hardware control values to respective devices. In particular, the FIFO buffer device 304C includes two DAC trigger terminals, two ADC trigger terminals, one DIO trigger terminal, and a time terminal. The two DAC trigger terminals are connected to D terminals of the DAC trigger-enable unit 312A; the two ADC trigger terminals are connected to D terminals of the ADC trigger-enable unit 312C; and the time terminal is connected to the comparator device 310. An output port of the comparator device 310 is connected to EN terminals of the respective DAC, ADC, DIO trigger-enable units 312A, 312B, 312C. A first output port of the DAC trigger-enable unit 312A is connected to a trigger terminal of the first FIFO buffer device 304A; and a second output port of the DAC trigger-enable unit 312A is connected to a trigger terminal of the second FIFO buffer device 304B. An output port of the DIO trigger-enable unit 312B is connected to an input port of the DIO unit 318. A first output port of the ADC trigger-enable unit 312C is connected to the ADC buffer device 322A; and a second output port of the ADC trigger-enable unit 312C is connected to the ADC buffer device 322B. The ADC buffer device 322A includes an input port connected to an output port of the ADC unit 320A; and the ADC buffer device 322B includes an input port connected to an output port of the ADC unit 320B. An output port of the ADC buffer device 322A is connected to a first input port of the multiplexer device 306B; an output port of the ADC buffer device 322B is connected to a second input port of the multiplexer device 306B. The signals from the output ports of the ADC trigger-enable unit 312C trigger the release of information (e.g., the magnetic resonance detection signal) stored in the ADC buffer devices 322A, 322B into the computer system.

The signal processing unit 300 is configured to provide deterministic triggering and controlling output of the DAC units 316A, 316B, the DIO unit 318, and the ADC units 320A, 320B by operation of respective trigger-enable units 312A, 312B, 312C. In some implementations, each trigger-enable unit 312A, 312B, 312C is operated independently while maintaining time synchronization and phase alignment of the output of the DAC units 316A, 316B, the DIO unit 318, and the ADC units 320A, 320B. In some implementations, the respective trigger-enable units 312A, 312B, 312C are also configured to disable DAC playback, ADC reading, and DIOs. In certain instances, the trigger-enable units 312A, 312B, 312C can be enabled and disabled multiple times in a pulse sequence.

In some implementations, the DAC trigger-enable unit 312A, the ADC trigger-enable unit 312B, and the DIO trigger-enable unit 312C ensure phase coherence of the DAC units 316A, 316B, the ADC units 320A, 320B, and the DIO unit 318. During operation, hardware trigger signals are received by the respective trigger-enable devices 312A, 312B, 312C from the FIFO buffer device 304C; and may be transmitted to the respective FIFO buffer devices 304A, 304B, the DIO unit 318, and the ADC buffer devices 322A, 322B according to the timestamp values in the hardware control sequence. For example, when a timestamp value in the hardware control sequence and carried by a timeline trigger signal from the FIFO buffer device 304C matches the time value from the internal clock 308, the trigger-enable units 312A, 312B, 312C are turned on allowing hardware trigger signals to be transmitted from the D terminals to the Q terminals, which are then used to enable the FIFO buffer devices 304A, 304B and the ADC buffer devices 322A, 322B. When the FIFO buffer devices 304A, 304B and the ADC buffer devices 322A, 322B are enabled, the digital IF signal values stored in the FIFO buffer devices 304A, 304B are transmitted out of the controller unit 104 to the respective DAC units 316A, 316B; and the magnetic resonance detection signals stored at the ADC buffer devices 322A, 322B are transmitted out of the controller unit 302 for example, to the signal processing unit 102. In this case, outputs from the DAC units 316A, 316B, the ADC units 320A, 320B, and the DIO unit 318 are synchronized relative to one another.

FIG. 3B is a schematic diagram 330 of an example data format of the FIFO buffer device 304C of the example signal processing unit 300 in FIG. 3A. As shown in FIG. 3B, the FIFO buffer device 304C contains multiple frames describing a stream of events, e.g., hardware control values at respective timestamp values. For example, when each frame has a length of 64 bits, each frame may include a timestamp section of 48 bits, a DAC trigger section of two bits corresponding to the DAC units 316A, 316B, an ADC trigger section of two bits corresponding to the ADC units 320A, 320B, and a DIO toggle section of twelve bits. In some instances, the frame of the FIFO buffer device 304C may have a different length and sections may have different section length according to the number of ADC and DAC units and the digitally controlled devices in the transmitter and receiver circuits.

In certain examples, the internal clock is a 48-bit timeline clock and starts when an experiment is triggered externally. When the timestamp value of a timestamp section in a frame 332 matches a current value of the internal clock, the event, which is defined by the hardware control values in the respective ADC section 334C, DAC section 334B, and the DIO toggle section 334A in the frame 332, is communicated to the respective trigger-enable units 312A, 312B, 312C through the respective terminals.

In some implementations, by operation of the comparator device 310, the timestamp value of the timestamp section 334D in a frame 332 is compared with the current time value from the internal timer 308. When the timestamp value equals the current time value, the respective trigger-enable units 312A, 312B, 312C are enabled; and the DIO trigger values, the DAC trigger values, and the ADC trigger values stored in the respective sections 334A, 334B, 334C in the frame 332 are passed from the D terminals to the Q terminals of the trigger-enable units 312A, 312B, 312C. In particular, when the DAC trigger-enable unit 312A is enabled, the DAC trigger value is communicated to the trigger terminals of the respective FIFO buffer devices 304A, 304B; and the digital IF signal values in current frames of the FIFO buffer devices 304A, 304B are transferred to the respective DAC units 316A, 316B. When the DIO trigger-enable unit 312B is enabled, the DIO trigger value is communicated to the DIO unit 318; and further to the respective digital control devices in the transmitter unit and the receiver unit (e.g., the switch devices 232, 252 of the transmitter unit 204 and the receiver unit 244 in FIGS. 2A-2B). When the ADC trigger-enable unit 312C is enabled, the ADC trigger values in the frame 332 is transferred to the ADC delay device 314 which is used to control the respective ADC buffer devices 322A, 322B associated with the respective ADC units 320A, 320B.

In some implementations, when the timestamp value in a frame 332 does not equal the current time value of the internal clock 308, the trigger-enable units 312A, 312B, 312C are disabled. In this case, the DAC trigger values, the ADC trigger values, and the DIO trigger values of the frame 332 are not transferred to the respective devices.

In some implementations, the DAC units 316A, 316B are configured to receive the digital IF signal values from the FIFO buffer devices 304A, 304B according to the hardware control sequence stored in the FIFO buffer device 304C; convert the digital IF signal values to the analog IF I-quadrature and Q-quadrature control signals; and output the analog IF I-quadrature and Q-quadrature control signals to the transmitter unit (e.g., the transmitter unit 204 in FIG. 2A. In some implementations, the DIO unit 318 receives digital trigger signals and converts them into a form appropriate to drive hardware, e.g., emitter coupled logic (ECL) signal, transistor-transistor logic (TTL) signal, etc.

FIG. 4 is a flow diagram showing aspects of an example process 400. The example process 400 can be performed, for example, by operation of a magnetic resonance system. For instance, operations in the example process 400 may be performed by operation of the example magnetic resonance system 100, 200, 240 shown in FIGS. 1, 2A-2B, the signal processing unit 300, 340 in FIG. 3A, 3C, or another type of system with additional or different bypass circuit. The example process 400 may include additional or different operations, including operations performed by additional or different components, and the operations may be performed in the order shown or in another order. In some cases, operations in the example process 400 can be combined, iterated or otherwise repeated or performed in another manner.

In some cases, the operations in the example process 400 shown in FIG. 4 are implemented as processes to generate and synchronize a magnetic resonance control signal and digital control signals for the transmitter unit 122, 204 in FIGS. 1 and 2A; and processes to receive magnetic resonance detection signals from the receiver unit 124, 244 in FIGS. 1 and 2B.

At 402, a pulse profile is identified. In some implementations, a pulse profile includes a target pulse or a series of target pulses to be used in performing a magnetic resonance measurement on a sample in a magnetic resonance system. For example, a pulse profile includes a time series of amplitudes and a time series of phases for a target pulse or multiple target pulses in a pulse sequence. In certain instances, multiple pulse profiles can also be identified. In some instances, when a pulse profile includes multiple pulses, the pulse profile may include one or more time delays separating two respective pairs of neighboring pulses. In some implementations, the pulse profile is identified by operation of the data processing apparatus 102.

In some implementations, a pulse in a pulse profile is characterized by pulse parameters. For example, a target pulse may include multiple pulse intervals; and each pulse interval is characterized with an amplitude, a phase, a frequency, and a time duration. In some implementations, the pulse parameters of the pulses in the pulse profile dictate the amplitude and phase envelopes of a digital IF signal over the corresponding pulse intervals.

FIG. 5A includes a time series 500 of amplitudes of pulse intervals in a pulse and a time series 502 of phases of the pulse intervals in the pulse in a time period of 500 ns. As shown in FIG. 5A, the pulse includes ten random pulse intervals, each of which is defined by a respective amplitude, phase, and time duration. As shown in FIG. 5A, the example pulse profile includes ten pulse intervals. Each of the ten pulse intervals may have at least one distinct pulse parameter. In some implementations, the ten pulse intervals in the example pulse are consecutive. For example, a first pulse interval has an amplitude of 1, a phase of 15 degrees, and a time duration of 60 ns; a second pulse interval following the first pulse interval has an amplitude of 0.48, a phase of -150 degrees, and a time duration of 40 ns; and a third pulse interval following the second pulse has an amplitude of 0.65, a phase of - 180 degrees, and a time duration of 80 ns. In some instances, the pulse profile may include a different number of pulse intervals, pulse intervals in a different order, pulse intervals with different pulse parameters, or may be configured in a different manner.

In some instances, a pulse profile may be pre-configured and stored in a memory unit (e.g., the memory unit 116 of the data processing apparatus 102). In some instances, the pulse profile may be created on the data processing apparatus 102 or specified by a user. The pulse profile may be received from a user device communicably connected to the data processing apparatus 102, for example, through a local network. In some instances, a pulse profile may be edited or modified by a user. The pulse profile can be stored in the memory unit 116 of the data processing apparatus 102. In some instances, a pulse profile can be selected from the memory unit according to the magnetic resonance measurement, the characteristics of the resonator device and the samples, and other factors. In some instances, a pulse profile can be generated, edited, and modified by a user. For example, a user can generate a pulse profile by specifying target pulses (e.g., phases, amplitudes, and time durations) and time delays for a type of magnetic resonance measurement. A generated pulse profile can be saved in the memory unit.

In some instances, the pulse profile may be modified at any stage of a magnetic resonance measurement such that the pulse parameters of the pulses can be changed, updated, or modified according to the sample in the resonator unit and requirement of the magnetic resonance measurement. For example, online adaptive updates can be used based on feedback from the magnetic resonance detection signal.

At 404, digital IF signal values are generated. In some implementations, the digital IF signal values are generated based on the identified pulse profile. In some implementations, the pulse sequence in an identified pulse profile can be parsed to identify individual pulses in the pulse profile, time delays, and acquisition periods in the pulse sequence. In some implementations, the digital IF signal values are generated by modulating respective amplitude envelopes of the individual pulses in the identified pulse profile using a digitally generated intermediate frequency carrier signal (e.g., a digital IF carrier signal). In some implementations, the phase of the digital IF carrier signal is shifted according to the phase envelope of the individual pulse in the respective pulse intervals. In some implementations, a digital IF carrier signal has a frequency (e.g., the intermediate frequency) of 200 MHz or another value, which may be determined by desired bandwidth and limitations of DAC units and ADC units. In some implementations, the digital IF carrier signal and the digital IF signal values are generated, by operation of the processor unit 112 of the data processing apparatus 102.

In some implementations, the digital IF signal values are obtained by sampling the modulated pules at a sampling time. In some instances, the sampling time for obtaining the digital IF signal values can be configured according to the intermediate frequency, resolution of the signal processing devices (e.g., DAC units), or other factors. In some implementations, the digital IF signal values are obtained at a sampling time of 1 ns, 2 ns, or another value. In some implementations, the digital IF signal values are in the range of -1 and 1. In some implementations, the digital IF signal values include information of the time-dependent amplitudes and phases of the target pulse in the pulse profile.

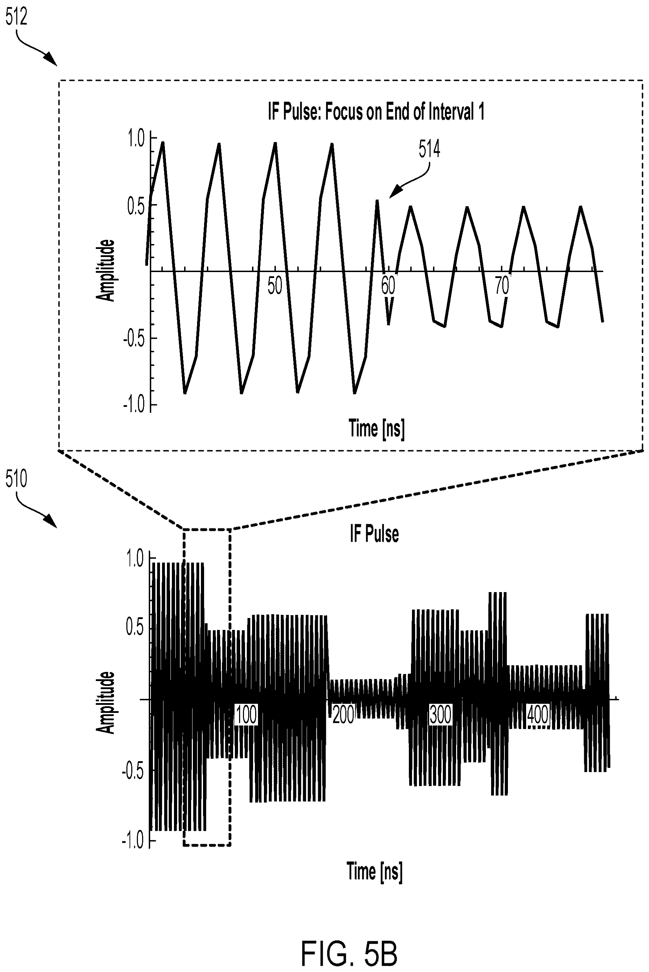

FIG. 5B is a plot 510 showing digital IF signal values as a function of time. In some implementations, the digital IF signal values are generated based on the time series 500, 502 of the amplitudes and phases of the example pulse in the example pulse profile shown in FIG. 5A. In some implementations, the digital IF signal values represent a modulated pulse using the digital IF carrier signal. The modulated pulse has an oscillating waveform with a time-dependent amplitude and phase. In other words, the modulated pulse has an amplitude envelope defined by the amplitude envelop 500 of FIG. 5A; and phases of waveforms in respective pulse intervals defined by the phases for the respective pulse intervals as shown in the phase envelope 502 of FIG. 5A and are referenced to t = 0. FIG. 5B further includes a zoom-in view 512 of the time series of the digital IF pulse in a time window of 40-80 ns. A discontinuity 514 in the digital IF pulse is caused by the difference between the phases (e.g., 15 and -150 degrees) of the two pulse intervals shown the phase envelop 502 in FIG. 5A.

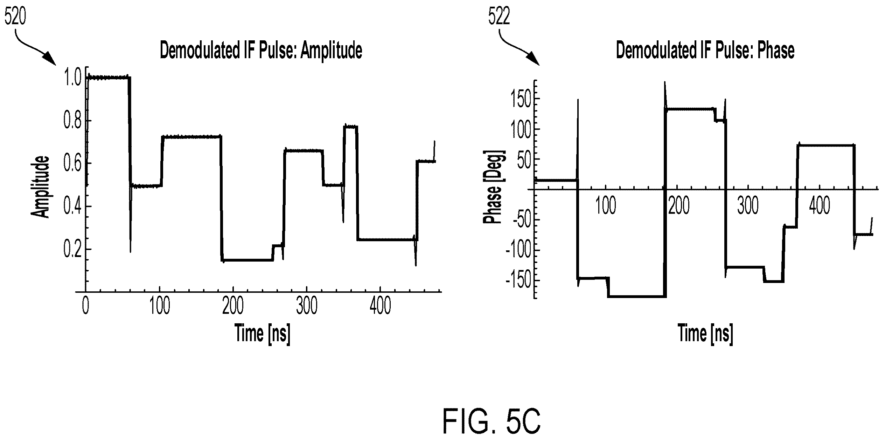

FIG. 5C includes a time series 520 of amplitudes and a time series 522 of phases of the example pulse as shown in FIG. 5A and a reconstructed pulse. The amplitudes and phases of the reconstructed pulse are determined by demodulating the modulated pulse shown in FIG. 5B using the same digital IF carrier signal. As shown in FIG. 5C, the amplitudes and phases of the original pulse and the reconstructed pulse are consistent with each other. Overshoots in amplitudes and phases of the reconstructed pulse are observed particularly at boundaries between two neighboring pulse intervals.

In some implementations, a magnetic resonance control signal is generated by processing two digital IF signals, e.g., a digital I-quadrature signal and a digital Q-quadrature signal. In some instances, the digital Q-quadrature signal has a phase which is shifted relative to the phase of the digital I-quadrature signal. In this case, the digital IF signal values include a time series of digital I-quadrature signal values obtained by sampling the digital I-quadrature signal; and a time series of digital Q-quadrature signal values obtained by sampling the digital Q-quadrature signal. The time series of the digital Q-quadrature signal values are phase-shifted relative to the time series of I-quadrature signal values. The methods and systems presented here allow image rejection, sidebands suppression, and LO suppression of by controlling the relative phase and amplitudes of the digitally generated digital Q-quadrature and I-quadrature signal values. In some instances, the phase shift may be determined when the spectrometer is initially configured or in another manner.

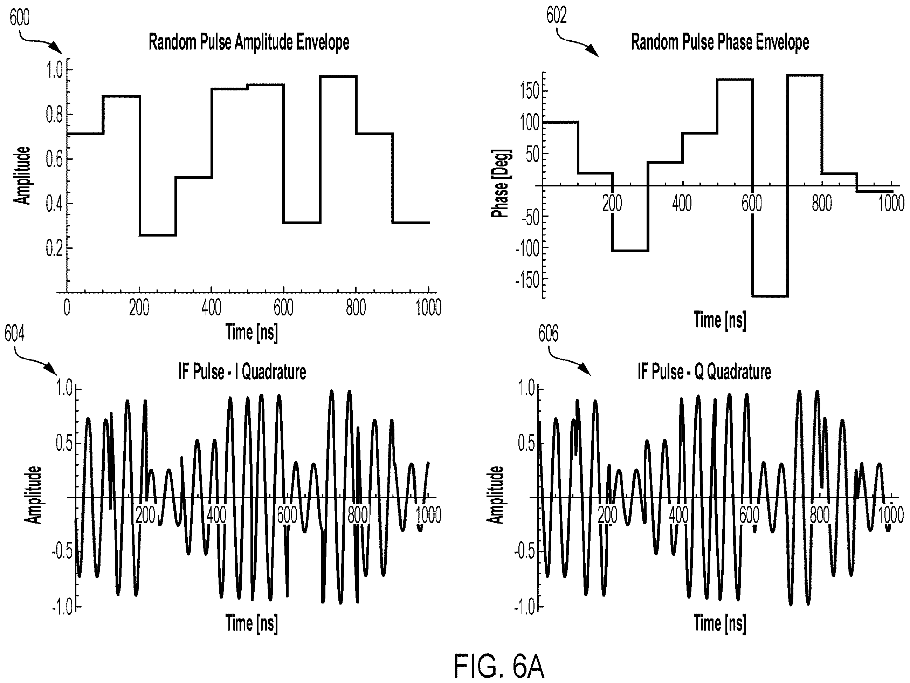

FIG. 6A includes an amplitude envelope 600 of a target pulse in an example pulse profile, a phase envelope of the target pulse in the example pulse profile, first digital IF signal values 604, and second digital IF signal values 606. As shown in FIG. 6A, the target pulse includes ten pulse intervals; and each pulse interval is 100 ns. The first and second digital IF signal values 604, 606 are generated based on the time series of amplitudes and phases 600, 602 of the target pulse. In particular, the first and second digital IF signal values shown in FIG. 6A are generated by modulating the pulse with the amplitudes and phases shown in plots 600, 602 using a digital IF carrier signal with an intermediate frequency of 200 MHz. The first digital IF signal values 604 is generated based on the time series 600, 602 of the pulse in the pulse profile; and the second digital IF signal values 606 is obtained by phase shifting the first modulated pulse. In some instances, the phase shift between the first and second digital IF signal values is less than, equal to, or greater than 90 degrees. In some implementations, the first digital IF signal values 604 represents a digital I-quadrature signal; and the second digital IF signal values 606 represents a digital Q-quadrature signal. In some implementations, digital I-quadrature and Q-quadrature signal values are obtained by sampling the modulated pulse at a sampling time (e.g., 1 ns).

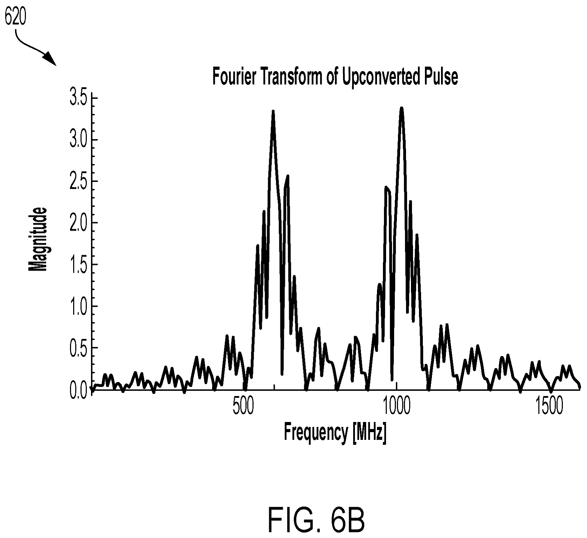

FIG. 6B includes Fourier components 620 of a first output signal of an IQ mixer model. The IQ mixer model is a theoretical model, which generates output signal by multiplication of input signals. The first output signal is obtained by passing the digital IF signal values representing the first and second modulated pulses 602, 604 shown in FIG. 6A through the IQ mixer device. Local oscillator electrical signals at 800 MHz are received at the IQ mixer device. The effect of imperfections from the IQ mixer device can be seen by considering the frequency components of the first output signal. Two sideband signals at 600 MHz and 1 GHz are obtained.

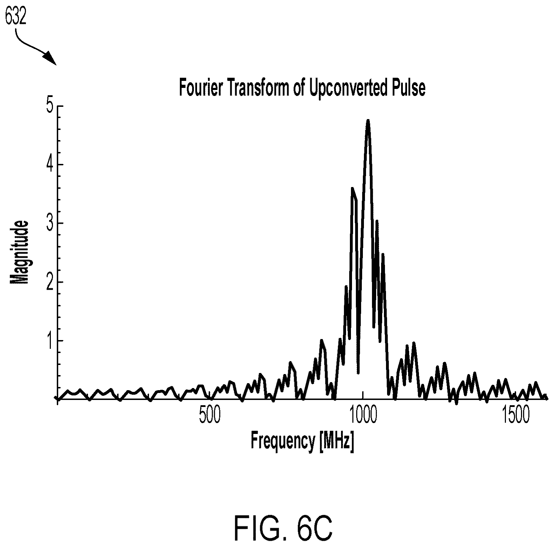

FIG. 6C includes Fourier components 632 of a third output signal of the IQ mixer device. The third output signal is obtained by phase-shifting the digital IF signal values representing the first and second modulated pulses 602, 604 shown in FIG. 6A and the passing the phase-shifted waveforms through the IQ mixer device. Local oscillator electrical signals at 800 MHz are received at the IQ mixer model. The phase-shifted waveforms can be used for image suppression. As shown in the plots 632 and 634. no sideband at 600 MHz is observed.

In some implementations, when a pulse sequence includes a series of pulses and time delays, rotation angles and phase shifts are specified for each pulse in the pulse sequence. The pulses in the pulse sequence are concatenated to one another separated by respective time delays. For example, a spin echo sequence can be represented by: $\pi/2)_x - \tau - \pi)_\phi$. Each pulse in the pulse sequence may be implemented as arbitrary waveforms that execute a corresponding operation (e.g., excitation, refocusing, etc.). In some implementations, pulse intervals in an individual pulse and all the pulses in the pulse sequence are referenced to $t = 0$ of the digital IF carrier signal. To maintain relative phases between pulses for arbitrary time delays, phase tracking of the digital IF carrier signal may be performed to determine corresponding relative phase shifts.

In some implementations, a relative phase shift is determined based on the duration of the time delay and a cycle time of the intermediate frequency. A relative phase shift is referenced to t=0 of the pulse sequence.

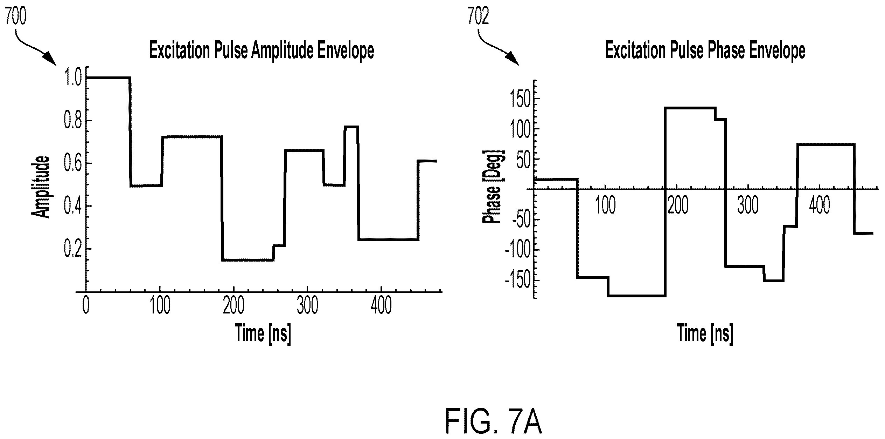

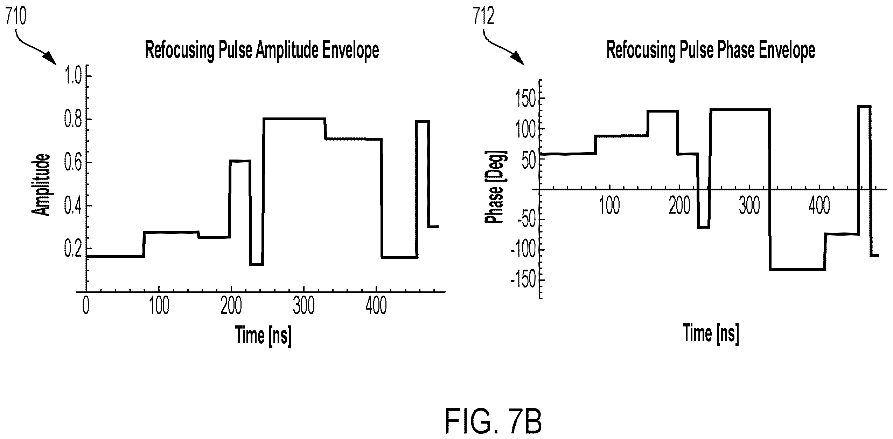

FIG. 7A includes time series 700, 702 of amplitudes and phases of a first example pulse in a pulse sequence. In some instances, the first example pulse may represent a pulse for $\pi/2)_x$ excitation in a spin echo sequence. FIG. 7B includes time series 710, 712 of amplitudes and phases of a second example pulse in the pulse sequence. In some instances, the second example pulse may represent a pulse for $\pi)_y$ refocusing in the spin echo sequence. As shown in FIGS. 7A and 7B, each of the first and second example pulses includes ten random pulse intervals; and each of the pulse intervals in a pulse is defined by parameters including a phase, an amplitude, and a time interval. The values of the parameters of the pulse intervals in a pulse are distinct from one another.

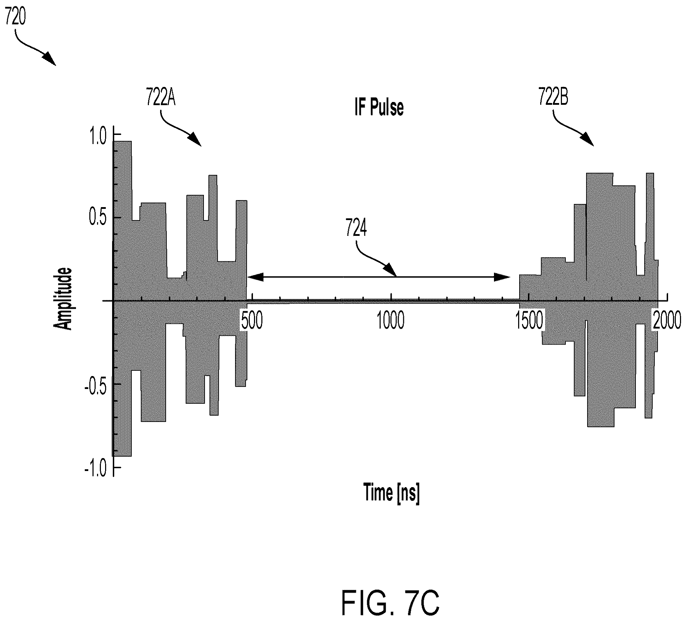

FIG. 7C is a plot 720 showing digital IF signal values determined based on the time series of amplitudes and phases 700, 702, 710, 712 of the first and second example pulses in FIGS. 7A-7B. As shown in FIG. 7C, the digital IF signal values include a first modulated pulse 722A and a second modulated pulse 722B which is concatenated to the first modulated pulse 722A after a time delay 724. In particular, the first modulated pulse 722A is generated by modulating the amplitude envelope 700 of the first example pulse shown in FIG. 7A using a digital IF carrier signal. The first modulated pulse 722A has a time-dependent phase which is determined according to the phase envelope 702 of the first example pulse shown in FIG. 7A. The second modulated pulse 722B is generated by modulating the amplitude envelope 710 of the second example pulse shown in FIG. 7B using the same digital IF carrier signal. The second modulated pulse 722B has a time-dependent phase determined according to the phase envelope 712 of the second example pulse shown in FIG. 7B. The digital IF signal values are generated by sampling the first and second modulated pulses 722A, 722B separated by the time delay 724. The digital IF carrier signal for modulating the amplitude envelopes 700, 710 of the first and second example pulses has an intermediate frequency of 200 MHz; and the time delay 724 equals 1000 ns.

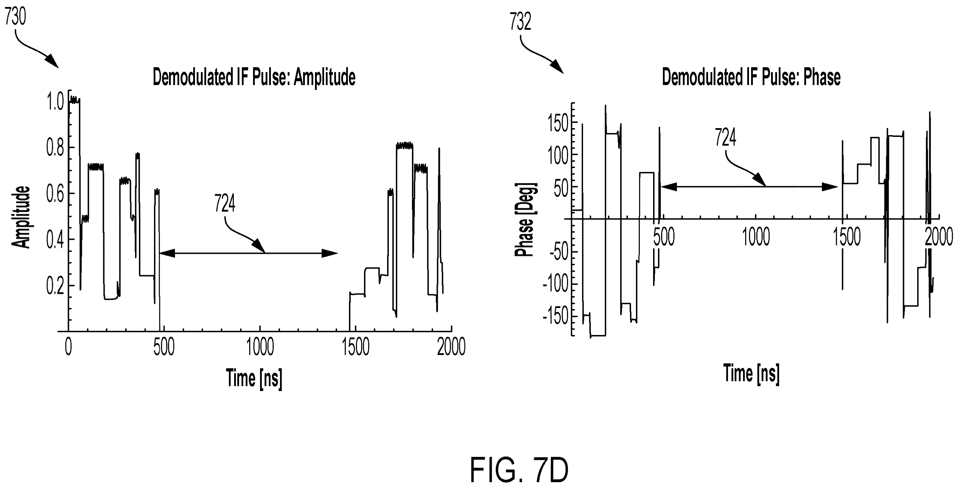

FIG. 7D includes plots 730, 732 showing time series of amplitudes and phases of a pulse sequence and a reconstructed pulse sequence. The pulse sequence includes the first and second pulses shown in FIGS. 7A and 7B separated by a time delay 724. The reconstructed pulse sequence is generated by demodulating the digital IF signal values in FIG. 7C using a digital IF carrier signal that is used to generate the digital IF signal values in FIG. 7B when modulating the pulse sequence. As shown in FIG. 7D, the reconstructed pulse sequence is consistent with the pulse sequence.

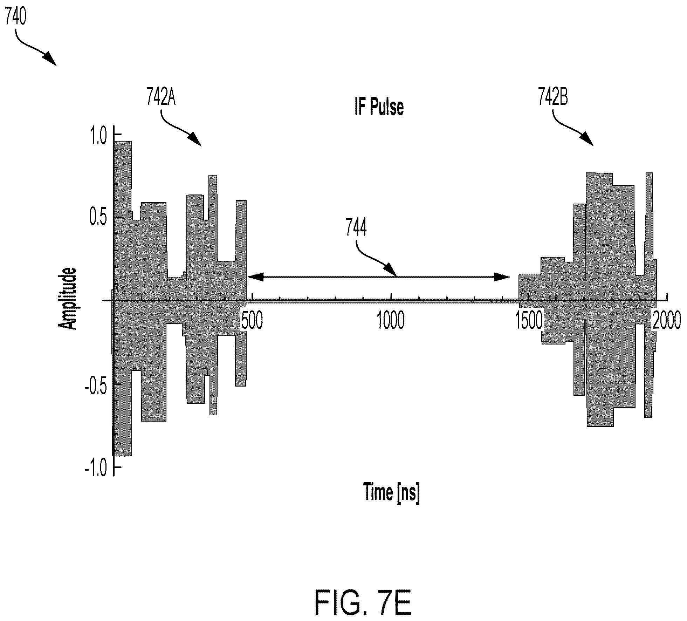

FIG. 7E is a plot 740 showing digital IF signal values determined based on the amplitude and phase envelopes 700, 702, 710, 712 of the first and second example pulses in FIGS. 7A-7B. As shown in FIG. 7E, the digital IF signal values include a first modulated pulse 742A and a second modulated pulse 742B which is concatenated to the first modulated pulse 742A after a time delay 744. In particular, the first modulated pulse 742A is generated by modulating the amplitude envelope 700 of the first example pulse shown in FIG. 7A using a digital IF carrier signal. The first modulated pulse 742A has a time-dependent phase which is determined according to the phase envelope 702 of the first example pulse shown in FIG. 7A. The second modulated pulse 742B is generated by modulating the amplitude envelope 710 of the second example pulse shown in FIG. 7B using the same digital IF carrier signal. The second modulated pulse 742B has a time-dependent phase determined according to the phase envelope 712 of the second example pulse shown in FIG. 7B. The digital IF signal values are generated by sampling the first and second modulated pulses 722A, 722B separated by the time delay 744. The digital IF carrier signal for modulating the amplitude envelopes 700, 710 of the first and second example pulses has an intermediate frequency of 200 MHz; and the time delay 724 equals 996 ns.

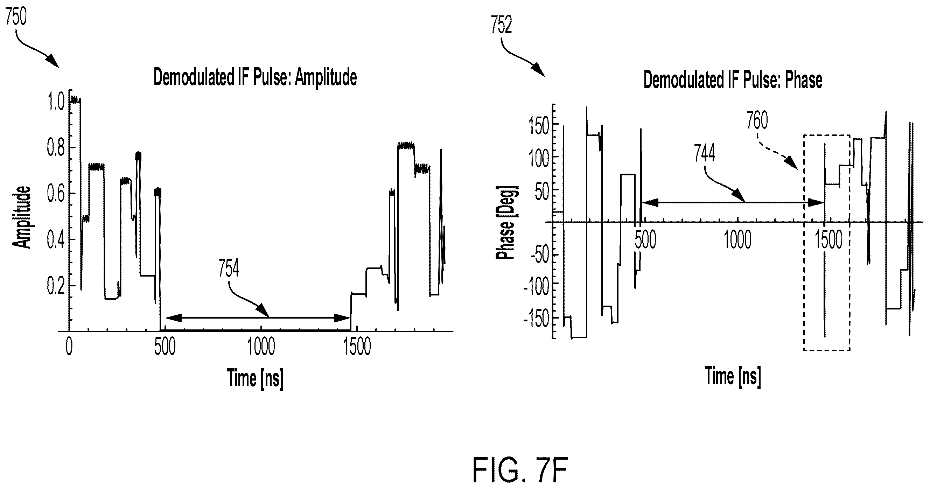

FIG. 7F includes plots 750, 752 showing amplitude and phase envelopes of a pulse sequence and a reconstructed pulse sequence. The pulse sequence includes the first and second pulses shown in FIGS. 7A and 7B separated by a time delay 744. The reconstructed pulse sequence is generated by demodulating the digital IF signal values in FIG. 7E using a digital IF carrier signal that is used to generate the digital IF signal values in FIG. 7E when modulating the pulse sequence. As shown in FIG. 7F, the reconstructed pulse sequence is consistent with the pulse sequence. As shown in FIG.7F, even if the time delay 744 is not an integer multiple of 5 ns, the correct phase can be still obtained.

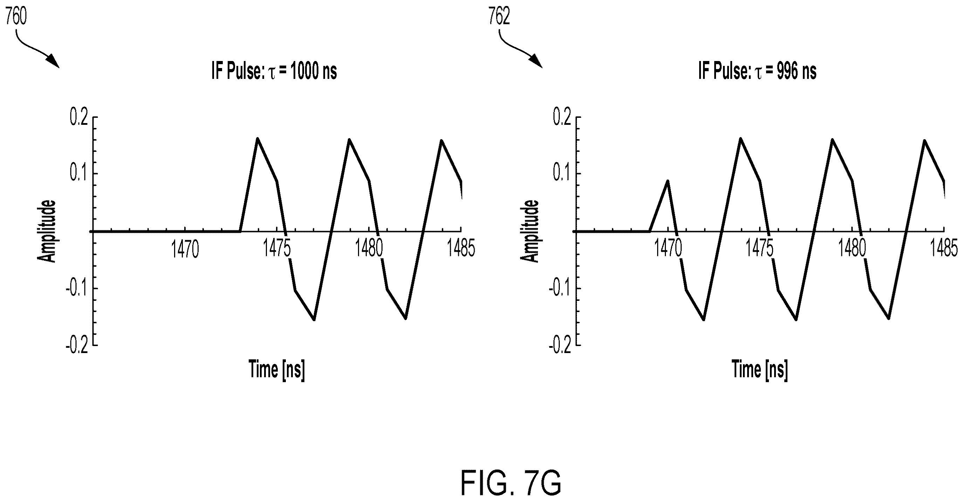

FIG. 7G includes a plot 760 showing a zoom-in view of the digital IF signal values 720 in FIG. 7C and a plot 762 showing a zoom-in view of the digital IF signal values 740 in FIG. 7E during a time window of 1465-1485 ns. As shown in FIG. 7G, initial phases of the second modulated pulses 722B and 742B in the digital IF signal values 720, 740 are different, which is caused by the difference in the two time delays 724, 744. In some instances, the differences between the two time delays 724, 744 and thus the differences between the two initial phases of the second modulated pulses 722B and 742B may contribute to unwanted phase shift to the phase envelope of the reconstructed pulse sequences.

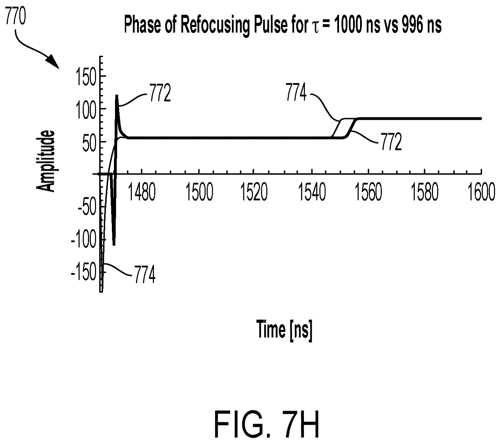

FIG. 7H is a plot 770 showing zoom-in views of the time series of phases of the two reconstructed pulse sequences shown in the plots 732, 752 in FIGS. 7D, 7F during a time window 1475-1600 ns. Curve 772 is the time series of phases of the reconstructed pulse sequence with the time delay of 1000 ns; and curve 774 is the time series of phases of the reconstructed pulse sequence with the time delay of 996 ns. Differences at around 1470 ns and 1550 ns are observed. In some implementations, phase shift may be applied to the phase envelope 702 of the first example pulse shown in FIG. 7A or the phase envelope 712 of the second example pulse shown in FIG. 7B by adding or subtracting a predetermined phase shift value to correct the unwanted phase shifts in the digital IF signal values.

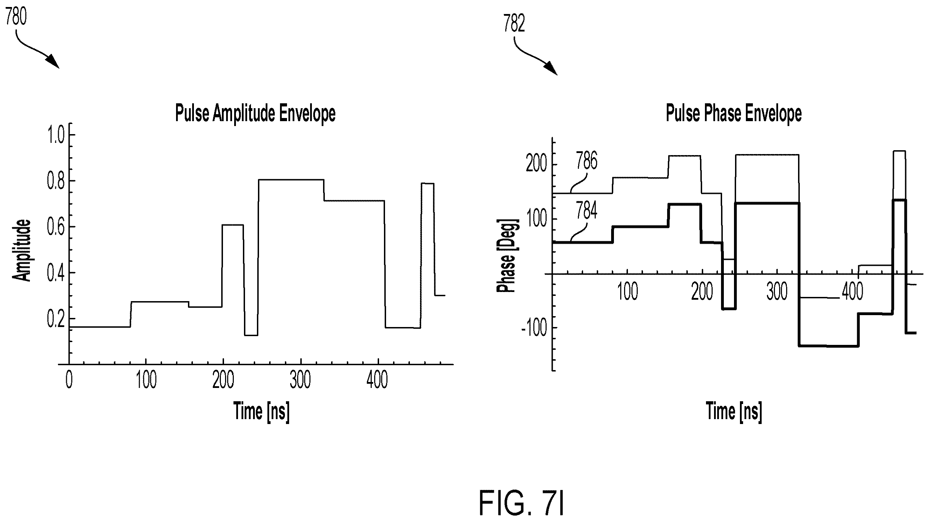

FIG. 7I shows a plot 780 showing the amplitude envelope of the second example pulse as shown in FIG. 7B and a plot 782 showing phase envelopes of the second example pulse before and after applying a phase shift to correct the effect from the time delay 744. Curve 784 represents the original phase envelope 712 of the second example pulse in FIG. 7B; and curve 786 represents the corrected phase envelope of the second example pulse which is shifted by about 90 degrees according to the time delay 744. In some instances, the phase shift applied to a pulse may be determined by the intermediate frequency, the time delay, and other parameters.

In some implementations, by operation of the processor unit 112 of the data processing apparatus 102, a hardware control sequence is generated based on information of a pulse sequence to be executed in a magnetic resonance system. Pulse sequence information of the pulse sequence, for example, the time delays between two pulses, and lengths of time segments for performing control operations (e.g., reading magnetic resonance detection signals, digitizing the magnetic resonance detection signals for correcting the pulse sequence, and other control operation) are used to construct a hardware control sequence. The hardware control sequence includes timestamps and hardware control values for respective time segments in the pulse sequence to control respective devices (e.g., the trigger-enable units 312A, 312B, 312C and FIFO buffer devices 304A, 304B in the signal processing unit 300). For example, the hardware control sequence (e.g., the hardware control sequence 900, 910 in FIGS. 9A-9B) includes timestamps for starting and stopping a DAC waveform playback, timestamps for starting and stopping a data acquisition process, timeline data for switching states of digitally controlled devices. In some instances, the hardware control sequence includes timeline data for performing other actions.

The hardware control values for each time segment are configured to control respective devices in DAC, ADC and DIO channels of the signal processing unit (e.g., the DAC channel 324A, the ADC channel 324B and the DIO channel 324C of the signal processing unit 300). In some implementations, devices in the signal processing unit of the magnetic resonance system that receive respective operations in a hardware control sequence are controlled by the hardware control values of the hardware control sequence depend on the design of the signal processing unit. Using the signal processing unit 300 shown in FIG. 3A as an example, the hardware control values are received by the devices 312A, 312B, 312C associated with the DAC units 316A, 316B, the ADC units 320A, 320B and the DIO device 318 are controlled according to the timestamps such that the outputs of the DAC units 316A, 316B, the ADC units 320A, 320B and the DIO device 318 are controlled. In particular, the hardware control values output from the DAC TRIG terminals of the third FIFO buffer device 304C are configured to determine the output of the first and second FIFO buffer devices and thus the outputs of the DAC units 316A, 316B; the hardware control values output from the ADC TRIG terminals of the third FIFO buffer device 304C are configured to determine the output of the ADC delay device 314 and thus the output of the ADC units 320A, 320B; and the hardware control values output from the DIO TRIG terminals of the third FIFO buffer device 304C are configured to determine the state of the digital control signals output from the DIO device 318. In some implementations, the hardware control sequence is determined according to the signal processing unit, e.g., width of the FIFO buffer devices, number of DAC units, number of DIO outputs, number of ADC units, etc.

In some instances, a set of digital IF signal values may be performed for any arbitrary number of times in a pulse sequence. The hardware control values may specify the same set of digital IF signal values multiple times enabling arbitrary repetition of a pulse in a magnetic resonance control signal. Once DAC waveform playback is enabled and a starting point defined, the DAC waveform playback proceeds sequentially through the waveforms until the DAC waveform playback is disabled. In some instances, once ADC digitizing is enabled, values are appended to a register for processing. In some instances, additional information may be added to the FIFO buffers in real-time during a given pulse sequence or experiment. In this way, adaptive control is enabled and repeated applications of a given DAC waveform only need to be stored in the memory unit 114 of the data processing apparatus 102 a single time and will be added sequentially to the DAC FIFO buffer devices 304A, 304B.

In some instances, the resolution of the timestamps in the hardware control sequence can be predetermined by the data processing apparatus 102, configured or modified by a user. In some instances, the resolution of the timestamps may be determined according to the operation frequency or other device parameters of the signal processing unit. For example, when an FPGA device with an operation frequency of 1 GHz is used in a signal processing unit, the resolution of the timestamps in the hardware control sequence is 1 ns.

In some implementations, the hardware control sequence may be compiled and converted, by operation of the processor units 112, into a series of hardware-specific commands according to the design and hardware configuration of the controller unit 122. In some implementations, when the hardware controls sequence is executed, the series of hardware-specific commands may be read into the signal processing unit (e.g., stored in the FIFO buffer device 304C of the signal processing unit 300 in FIG. 3) and executed by the signal processor unit. Each command includes timestamps and hardware control values corresponding to the respective time segments in the pulse sequence. In some implementations, when the hardware control sequence is executed, the series of hardware-specific commands is executed by the signal processing unit. In some instances, multiple copies of the series of commands are stored in the FIFO buffer device 304C. Each of the multiple copies of the series of commands can be executed multiple times. One of the commands in the series of commands includes a delay period between iterations of the pulse sequence.

When multiple pulse profiles are identified, multiple sets of digital IF signal values for the respective pulse profiles can be generated. Each set of digital IF signal values may have the same intermediate frequency or a distinct intermediate frequency. The multiple sets of digital IF signal values are combined to produce a multiple-resonance pulse. In some implementations, each set of the digital IF signal values are parsed into multiple subsets. Each subset represents a modulated pulse corresponding to a pulse in a pulse profile. In some instances, each subset represents a modulated pulse with a phase correction to account for effects, e.g., from a time delay or other effects. In some implementations, subsets in the multiple sets of digital IF signal values are stored separately in the memory unit 116. In some implementations, each subset is labeled with a pulse identifier, which indicates a memory address where the subset of digital IF signal values of a corresponding pulse is stored.

When a multiple resonance measurement is performed, a set of digital IF signal values may represent a multiple resonance pulse. In particular, the set of digital IF signal values may include multiple subsets of digital IF signal values, each corresponding to a modulated pulse at a distinct intermediate frequency. For example, when a first pulse profile and a second pulse profile are identified by operation of the data processing apparatus 102, pulses in the first pulse profile may be modulated by a first digital IF carrier signal with a first intermediate frequency; and pulses in the second pulse profile may be modulated by a second IF carrier signal with a second, distinct intermediate frequency. A first set of digital IF signal values is generated based on the first pulse profile; and a second set of digital IF signal values is generated based on the second pulse profile. The first and second sets of digital IF signal values are superposed to form a new set of digital IF signal values, which can be used in performing a multiple resonance measurement. In some instances, the first and second sets of digital IF signal values may be processed in another manner to form the new set of digital IF signal values for a multiple resonance measurement. In this case, the new set of digital IF signal values may be parsed into subsets; and each subset may be stored separately in the memory unit 116.

At 406, the digital IF signal values are stored. In some instances, after the subsets of digital IF signal values corresponding to the pulses in the pulse profile are determined, the subsets of digital IF signal values can be separately stored as individual waveforms in the memory unit 116. The multiple subsets of digital IF signal values can be later accessed by the controller unit 122 and used as input to the DAC units 214, 216. In some implementations, a subset of digital IF signal values corresponding to a pulse in a pulse profile to be executed by the magnetic resonance system include both the digital I-quadrature and Q-quadrature signal values; and the digital I-quadrature and Q-quadrature signal values for the pulse may be separately stored in the memory unit 116.

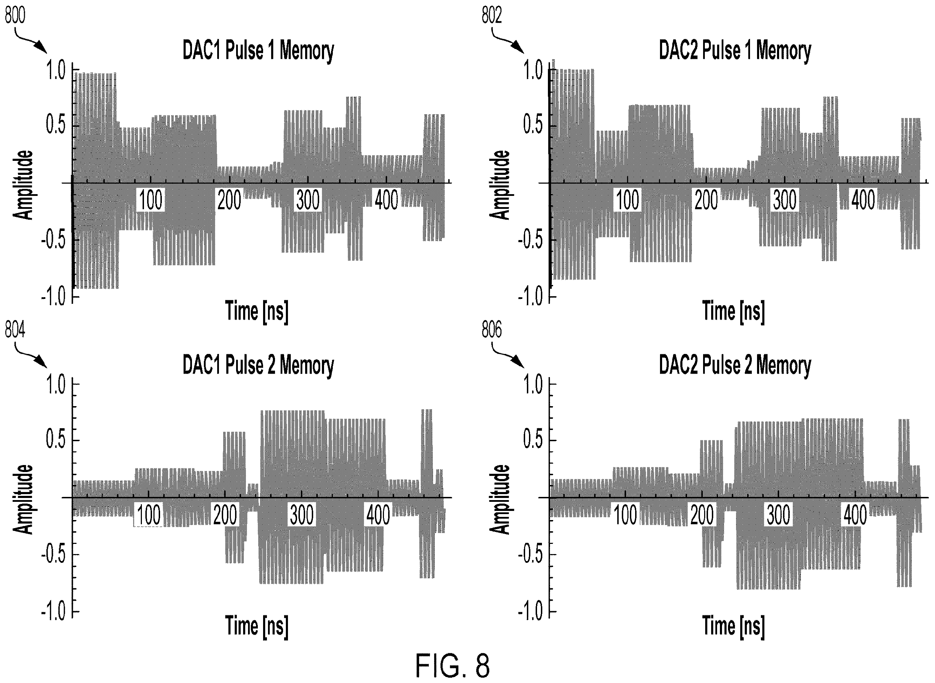

FIG. 8 includes plots 800, 802, 804, 806 of subsets of digital IF signal values of corresponding pulses in the pulse sequence. The subsets of digital IF signal values shown in FIG. 7C separately stored in memory unit for DAC waveform playback. In particular, a plot 800 shows digital I-quadrature signal values of the first modulated pulse 722A; a plot 802 shows digital Q-quadrature signal values of the first modulated pulse 722A; a plot 804 shows digital I-quadrature signal values of the second modulated pulse 722B; and a plot 806 shows digital Q-quadrature signal values of the second modulated pulse 722B. The digital Q-quadrature signal values and the digital I-quadrature signal values of the same modulated pulse are phase-shifted by 90 degrees relative to each other.

In some implementations, the hardware control sequence corresponding to a pulse sequence is also stored in the memory unit 116. In some instances, when configuring for a magnetic resonance measurement, subsets of digital IF signal values corresponding to pulses in a pulse sequence and a hardware control sequence or hardware-specific commands are obtained from the memory unit 116; and the subsets of digital IF signal values may be written to the FIFO buffer devices 304A, 304B in an order. The subsets of digital IF signal values are readout to the DAC units in the order as they are stored in the FIFO buffer devices according to the hardware control sequence. The subsets of digital IF signal values are converted to analog IF I-quadrant and Q-quadrant control signals in the order, which are further converted to the magnetic resonance control signal.

When the pulse sequence is executed in the magnetic resonance system, the output of the DIO unit is determined according to the hardware control sequence. The output of the DIO unit is configured to synchronize transmission electronics in the transmitter unit and receiver electronics in the receiver unit.

FIGS. 9A-9B include a plot 900 and a corresponding table 910 of an example hardware control sequence. The hardware control sequence may be determined based on pulse sequence information of a pulse sequence. The hardware control sequence is configured to control devices or units of a controller unit 122, 202, 242 of a magnetic resonance system 100, 200, 240 as shown in FIGS. 1, 2A-2B. In some instances, the hardware control sequence may be used to control other devices or units in the magnetic resonance system. As shown in FIGS. 9A-9B, the example hardware control sequence includes a series of timestamp values and a series of control actions or a series of corresponding hardware control values for controlling output of respective channels in the signal processing unit, e.g., DAC channels, ADC channels and DIO channels.

In some implementations, the example hardware control sequence in FIGS. 9A-9B shows aspects of a full echo spin sequence. For example, at $t = t_0 = 0$, the hardware control values include DIO1 on, DIO2 off, DACs off, and ADCs off; at $t = t_1 = 25$ ns, the hardware control values include DIO1 on, DIO2 off, DACs on, and ADCs off; $t = t_2 = 125$ ns, hardware control values include DIO1 on, DIO2 off, DACs off, and ADCs off; $t = t_3 = 150$ ns, the hardware control values include DIO1 off, DIO2 off, DACs off, and ADCs off; $t = t_4 = 1100$ ns, the hardware control values include DIO1 on, DIO2 off, DACs off, and ADCs off; $t = t_5 = 1125$ ns, the hardware control signal values include DIO1 on, DIO2 off, DACs on, and ADCs off; $t = t_6 = 1225$ ns, the hardware control signal values include DIO1 on, DIO2 off, DACs off, and ADCs off; $t = t_7 = 1250$ ns, the hardware control signal values include DIO1 off, DIO2 off, DACs off, and ADCs off; $t = t_8 = 1325$ ns, the hardware control signal values include DIO1off, DIO2 on, DACs off, and ADCs on; and $t = t_9 = 11325$ ns, the hardware control signal values include DIO1off, DIO2 off, DACs off, and ADCs off. During the time period between $t_8$ and $t_0$, the magnetic resonance system transfers a magnetic resonance control signal to the resonator device; and during the time period between $t_9$ and $t_8$, the magnetic resonance system receives a magnetic resonance detection signal from the resonator device.

In some instances, a hardware control sequence may be converted or compiled to hardware specific control commands according to the design of a signal processing unit. Hardware-specific commands may have a specific form that specifies hardware control values at respective timestamps. FIG. 3B shows an example format of hardware-specific commands from a hardware control sequence stored in a FIFO buffer device of a digital processing unit.

In some implementations, when a multiple resonance measurement is performed, a subset of digital IF signal values may include frequency multiplexed pulses. For example, pulses that are modulated at different intermediate frequencies can be superposed to each other. The subset of digital IF signal values representing a multiple resonance pulse can be converted to a magnetic resonance control signal and communicated to the resonator unit for the multiple resonance measurement. To demonstrate the effectiveness of the method, the superposed digital IF pulses can be demodulated independently using a respective IF carrier signal a respective IF signal to obtain the first or second digital IF pulses. In some instances, the subset of digital IF signal values may include three or more frequency multiplexed pulses. In some implementations, the IF frequencies of the digital IF carrier signals that are used to modulate the pulses are non-overlapping which are distinct from one another. The methods and systems presented here allow for simultaneous pulse transmission at multiple frequencies, performance of high-fidelity multifrequency experiments, and improved bandwidth by increasing the intermediate frequency. In some implementations, digital IF signal values representing frequency multiplexed pulses may be used in applications such as multi-qubit control, Double Electron-Electron Resonance (DEER) experiments, and other types of magnetic resonance applications. The frequency-multiplexed pulses can be transferred simultaneously to the DAC units and to the resonator device. Received signals from the ADC units may be demultiplexed at respective intermediate frequencies for detection.

FIG. 11A includes plots 1100, 1102 showing amplitude and phase envelopes of a first pulse in a pulse sequence and plots 1104, 1106 showing amplitude and phase envelopes of a second pulse in the pulse sequence. The first and second pulses are 1000-ns pulses; and each includes ten pulse intervals in ten equal time intervals.

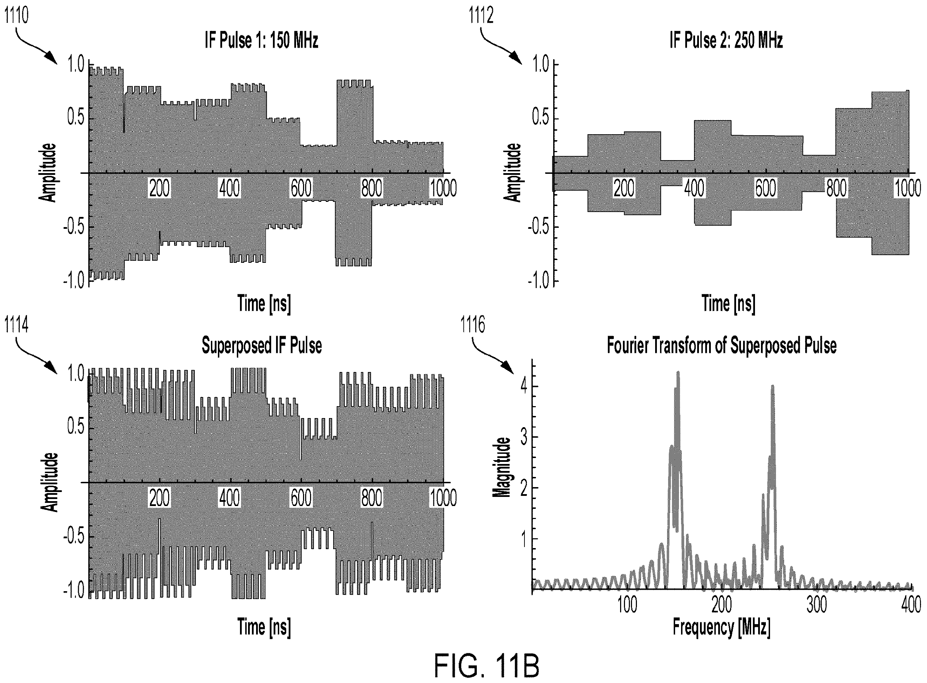

FIG. 11B includes a plot 1110 showing a first subset of digital IF signal values generated based on the amplitude and phase envelopes of the first pulse shown in FIG. 11A. The first subset of digital IF signal values are generated by modulating the amplitude envelope of the first pulse using a first digital IF carrier signal with a first intermediate frequency of 150 MHz. FIG. 11B further includes a plot 1112 showing a second subset of digital IF signal values generated based on the amplitude and phase envelopes of the second pulse shown in FIG. 11A. The second subset of digital IF signal values are generated by modulating the amplitude envelope of the second pulse using a second digital IF carrier signal with a second intermediate frequency of 250 MHz. FIG. 11B further includes a plot 1114 showing a third subset of digital IF signal values generated by superposing the first and second subsets of digital IF signal values; and includes a plot 1116 showing a Fourier transform of the third subset of digital IF signal values.

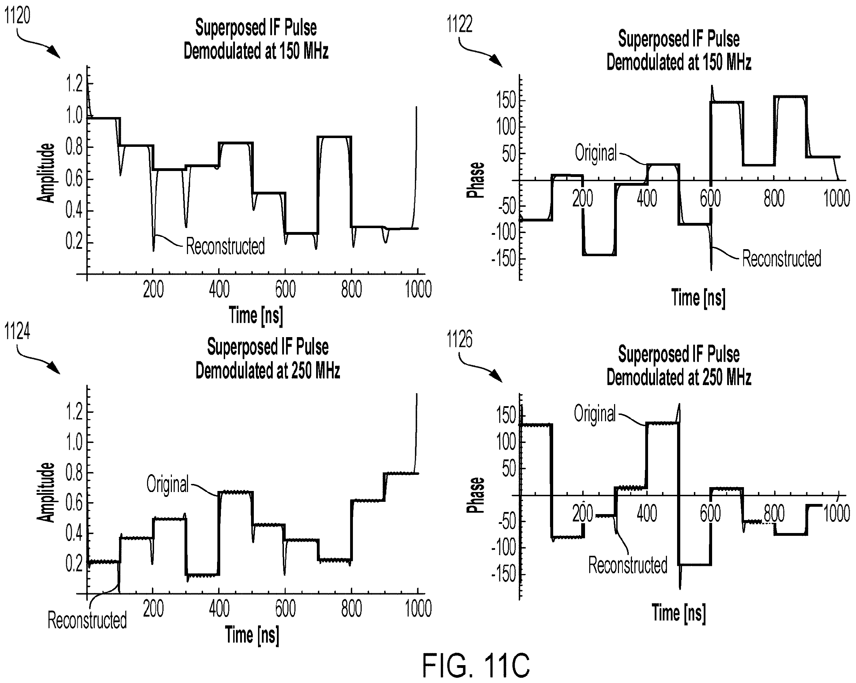

FIG. 11C includes plots 1120, 1122 showing amplitude and phase envelopes of the first pulse and a first reconstructed pulse by demodulating the third subset of digital IF signal values at the first intermediate frequency. FIG. 11C includes plots 1124, 1126 showing amplitude and phase envelopes of the second pulse and a second reconstructed pulse by decomposing the third subset of digital IF signal values at the second intermediate frequency. As shown in FIG. 11C, the reconstructed pulses match the original first and second pulses. Overshoots can be observed at boundaries of pulse intervals.

FIG. 12A includes plots 1200, 1202 showing amplitude and phase envelopes of a first pulse in a pulse sequence; plots 1204, 1206 showing amplitude and phase envelopes of a second pulse and a third pulse in the pulse sequence; and plots 1208, 1210 showing amplitude and phase envelopes of a fourth pulse in a pulse sequence. When the pulse sequence is a four-pulse double resonance sequence, the first, second, and fourth pulses are observer pulses in the doble resonance sequence; the third target pulse is a pump pulse in the four-pulse doble resonance sequence. In some instances, the pulse sequence can be used in biological EPR distance measurements or another type of measurement. Each of the first, second, third and fourth pulses is a 1000-ns pulse including ten pulse intervals with equal time intervals (e.g., 100 ns). In some implementations, the first, second, third, and fourth pulses can be concatenated with time delays to form the pulse sequence.

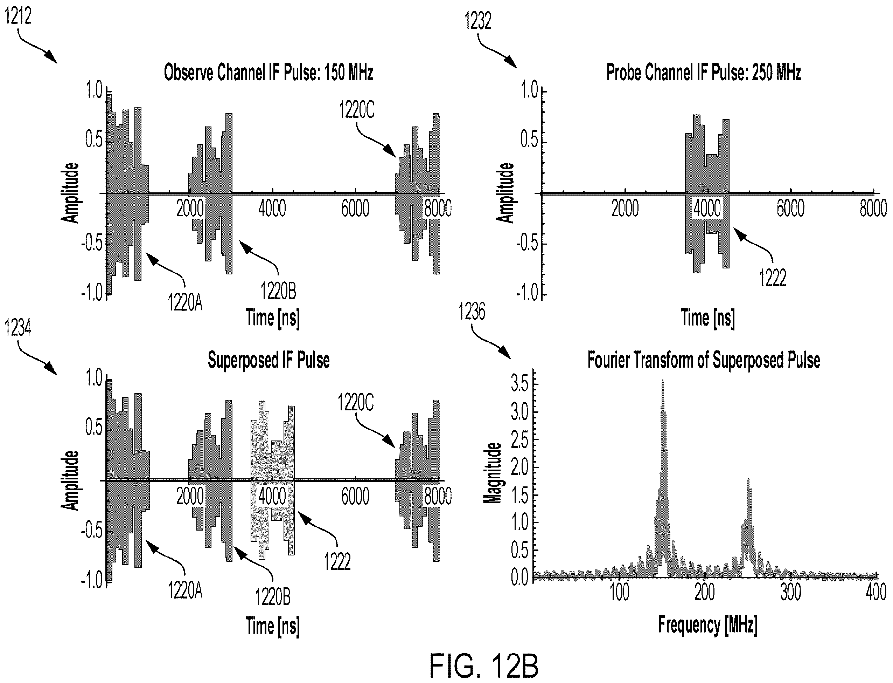

FIG. 12B includes a plot 1212 showing aspects of a first set of digital IF signal values including three subsets of digital IF signal values 1220A, 1220B, 1220C. The first set of digital IF signal values is generated by modulating the first, second and fourth pulses in the pulse sequence shown in FIG. 12A using a first digital IF carrier signal with an intermediate frequency of 150 MHz and by correcting phase shifts according to time delays between two subsets of digital IF signal values. The first set of digital IF signal values is configured to deliver observer pulses to a resonator. FIG. 12B also includes a plot 1232 showing aspects of a second set of digital IF signal values including a third subset of digital IF signal values 1222. The second set of digital IF signal values is generated by modulating the third pulse in the pulse sequence shown in FIG. 12A using a second digital IF carrier signal with a second intermediate frequency of 250 MHz and by correcting phase shifts according to a time delay between the second and the third pulses. FIG. 12B includes a plot 1234 showing a third set of digital IF signal value which is generated by superposing the first and second digital IF signals and a plot 1236 showing a corresponding Fourier transform of the third set of digital IF signal values showing two frequency peaks at 150 MHz and 250 MHz corresponding to the intermediate frequencies used to modulate the observer pulses and the pump pulse in the pulse sequence.

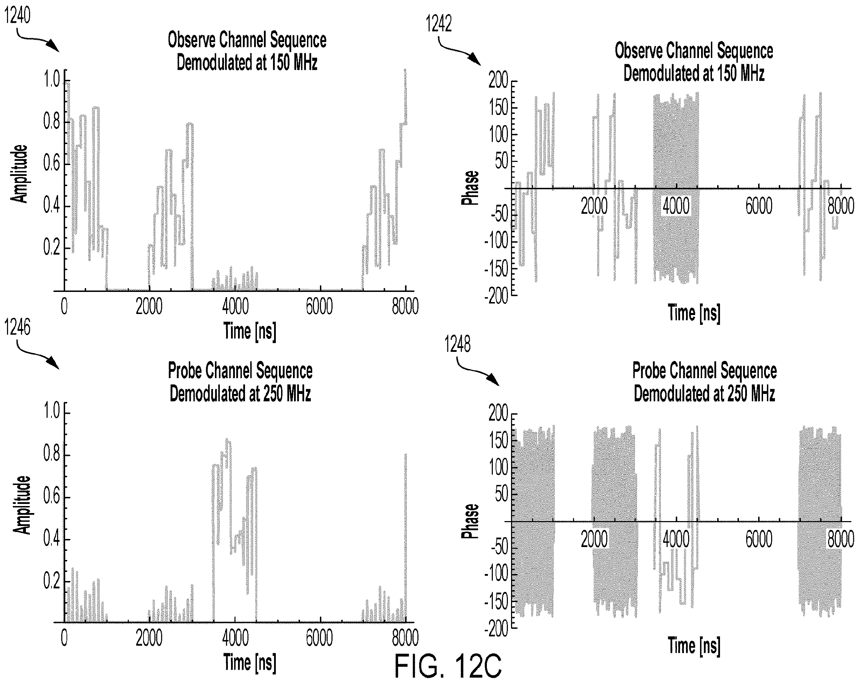

FIG. 12C includes plots 1240, 1242 showing amplitude and phase envelopes of an original pulse sequence and a first reconstructed pulse sequence by demodulating the third set of digital IF signal values shown in FIG. 12B at the first intermediate frequency of 150 MHz. Both of the amplitude and phase envelopes of the reconstructed pulse sequence are consistent with the first, second and fourth pulses in the pulse sequence as shown in FIG. 12A. FIG. 12C also includes plots 1246, 1248 showing amplitude and phase envelopes of the original pulse sequence and a second reconstructed pulse sequence by demodulating the third set of digital IF signal values shown in FIG. 12B at the second intermediate frequency of 250 MHz. Both of the amplitude and phase envelopes of the reconstructed pulse sequence are consistent with the third pulses in the original pulse sequence as shown in FIG. 12A. The original pulse sequence includes the first, second, third, and fourth pulses in FIG. 12A separated by respective time delays defined in FIG. 12B.

At 408, the digital IF signal values are converted to analog IF electrical signals by operation of the controller unit 122, 202, 300 in FIGS. 1, 2A, 3. In some implementations, the digital IF signal values are received and converted to respective analog IF electrical signals by operation of respective DAC units 214, 216, 316A, 316B. In some implementations, conversion and output of the analog IF electrical signal to the transmitter unit is controlled synchronized according to the hardware control sequence. In some implementations, a hardware control sequence is generated based on pulse sequence information corresponding to a pulse sequence to be executed by the magnetic resonance system. In some implementations, a hardware control sequence, specifying actions occurring at specific timestamps relative to a shared distributed clock is configured to coordinate and synchronize the control of the input to the DAC units, the ADC units, and the DIO devices. In some implementations, the hardware control values may include additional information, e.g., addresses of the DIO output terminals. In some instances, the format of each frame 332 in the third FIFO buffer device 304C may be different. For example, a frame 332 may have more sections containing hardware control values for respective devices; and each section in a frame 332 may have a different width.

In some implementations, averaging is achieved through combining copies of the given timeline into a larger, periodic timeline. In some instances, a circular FIFO buffer can be used to enable arbitrary averaging. In some instances, an additional time delay may be included in the timeline for averaging to account for T1 recovery. To avoid unneeded complexity in maintaining phase coherence, the time delay is an integer multiple of the period of the digital IF carrier signal. In some implementations, using the timeline for signal averaging ensures all data within an experiment, even across various scans for averaging, is phase coherent.

For example, the digital I-quadrature and Q-quadrature IF signal values are received and stored in respective FIFO buffer devices 304A, 304B of the signal processing unit 300. The outputs of the FIFO buffer devices 304A, 304B are controlled by control signals received at respective trigger terminals (TRIG). The control signals are generated according to the hardware control sequence (e.g., the timeline data 900, 910 as shown in FIGS. 9A-9B) received at the third FIFO buffer device 304C. Once the FIFO buffer devices 304A, 304B are enabled (e.g., the control signals at the TRIG terminals are in their first states), the digital IF signal values are then received at the DAC units 316A, 316B until the FIFO buffer devices 304A, 304B are disabled; analog Q and I control signals are generated by operation of the respective DAC units 316A, 316B; and the analog Q and I control signals are sent to the transmitter unit for further processing.

In some implementations, multiple analog IF electrical signals are generated and separated by time delays defined in the hardware control sequence. In particular, a time delay after generating a first analog IF electrical signal is implemented according to the hardware control sequence. After the time delay, second digital IF signal values are received at the DAC unit and converted to a second analog IF electrical signal separated from the first analog IF electrical signal by the time delay.

At 410, a magnetic resonance control signal is generated. In some implementations, a magnetic resonance control signal is generated by operation of the transmitter unit 122, 204 in FIGS. 1, 2A. In some implementations, the analog IF electrical signals are mixed with local oscillator (LO) electrical signals to produce a magnetic resonance control signal. The magnetic resonance control signal is a single side-band control signal by controlling of the relative phases of the digital Q-quadrature signal values and the digital i-quadrature signal values. In some implementations, the magnetic resonance control signal can be further filtered, amplified, or processed prior to delivering to the resonator device. The magnetic resonance control signal when delivered to the resonator device in the magnetic resonance system can generate the control field. When a plurality of pulse profiles is identified and a plurality of sets of digital IF signal values are generated, a plurality of magnetic resonance control signals are generated based on the plurality of sets of digital IF signal values.

In some implementations, a magnetic resonance detection signal (e.g., spin signal) can be received from the resonator unit and processed (e.g., amplified, filtered, down-converted, etc.) by the receiver unit 124, 244. In some implementations, a down-converted magnetic resonance detection signal at the intermediate frequency can be obtained using the mixer device 258 and digitized by operation of the ADC units 220 at the signal processing unit 244. In some instances, digital magnetic resonance detection signal values can be generated by the ADC units 220 and communicated from the signal processing unit 242 to the processor units where it can be demodulated at the intermediate frequency. In some instances, the demodulated magnetic resonance detection signal can be phase corrected. In some implementations, the methods and systems presented in this application allow the application of accurate and arbitrary phase correction to the magnetic resonance detection signal.

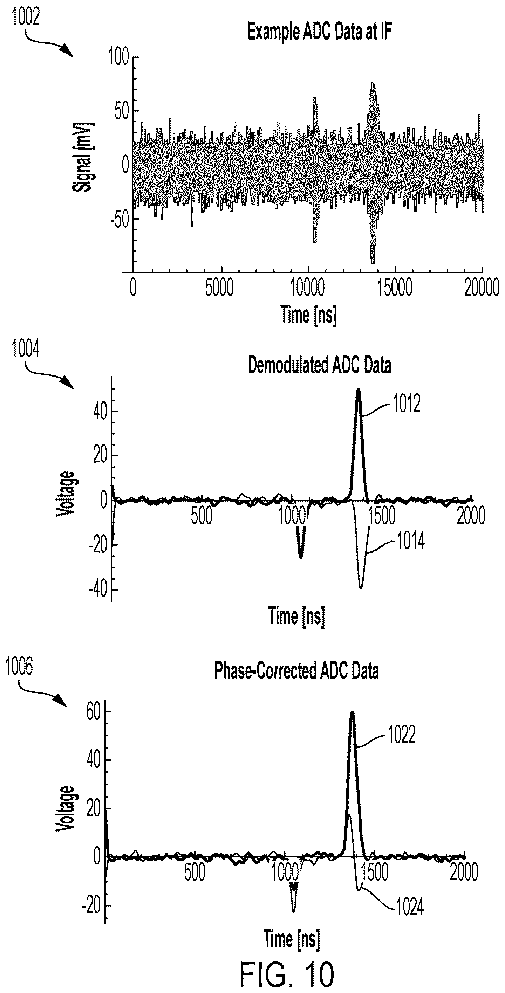

FIG. 10 includes a plot 1002 showing example ADC data as a function of time. The ADC data is obtained by digitizing raw data received at the ADC unit at the intermediate frequency of 200 MHz. This ADC data is at the output port of the ADC unit. In some instances, the example ADC data is from an experimental implementation of a similar spin echo sequence on an irradiated quartz spin sample. The residual resonator ringdown can be seen after the DIO2 toggle around 11000 ns; and the spin echo signal is seen around 14000 ns.

FIG. 10 includes a plot 1004 showing demodulated ADC data (mV) as a function of time (ns). The ADC data is demodulated, filtered, and decimated using a digitally generated IF carrier signal with an intermediate frequency to obtain a phase-sensitive signal, by operation of the data processing apparatus 102 in FIG. 1. As shown in FIG. 10, the demodulated ADC data includes a Q-quadrature signal 1012 and an I-quadrature signal 1014. The digital IF carrier signal is the same as the one used to modulate the pulses in a pulse sequence. FIG. 10 also includes a plot 1006 showing demodulated ADC data (mV) as a function of time (ns). The ADC data is phase shifted by 46 degrees to maximize the I-quadrature signal.

Some of the subject matter and operations described in this specification can be implemented in digital electronic circuitry, or in computer software, firmware, or hardware, including the structures disclosed in this specification and their structural equivalents, or in combinations of one or more of them. Some of the subject matter described in this specification can be implemented as one or more computer programs, i.e., one or more modules of computer program instructions, encoded on a computer storage medium for execution by, or to control the operation of, data-processing apparatus. A computer storage medium can be, or can be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially generated propagated signal. The computer storage medium can also be, or be included in, one or more separate physical components or media.

Some of the operations described in this specification can be implemented as operations performed by a data processing apparatus on data stored on one or more computer-readable storage devices or received from other sources.

In a general aspect of what is described above, a magnetic resonance system is operated.

In a first example, a magnetic resonance system includes data processing apparatus and a superheterodyne spectrometer system. The data processing apparatus generates digital intermediate frequency (IF) signal information based on a pulse profile. The digital IF signal information is configured to suppress an image sideband in a magnetic resonance control signal. The superheterodyne spectrometer generates the magnetic resonance control signal based on the digital IF signal information.

Implementations of the first example may include one or more of the following features. The digital IF signal information specifies one or more phase shifts based on a time series of phases specified by the pulse profile. The digital IF signal information includes a time series of I-quadrature signal values; and a time series of Q-quadrature signal values. The time series of Q-quadrature signal values are phase-shifted relative to the time series of I-quadrature signal values. The time series of I-quadrature signal values and the time series of Q-quadrature signal values each include a DC offset configured to reduce LO leakage. The digital IF signal information includes a plurality of sets of digital IF signal values based on a plurality of pulses in a pulse sequence; and the superheterodyne spectrometer system is configured to generate a plurality of magnetic resonance control signals based on the plurality of sets of digital IF signal values.

In a second example, a method of operating a magnetic resonance system includes, by operation of a computer system, identifying a pulse profile for a pulse to be generated by the magnetic resonance system; generating digital intermediate frequency (IF) signal values based on the pulse profile; storing the digital IF signal values in a memory unit;

and generating analog IF electrical signals based on the digital IF signal values. The method further includes mixing the analog IF electrical signals with local oscillator (LO) electrical signals to produce a magnetic resonance control signal; and delivering the magnetic resonance control signal to a resonator unit in the magnetic resonance system.

Implementations of the second example may include one or more of the following features. The pulse profile defines a time series of amplitudes and a time series of phases for the pulse. Generating the digital IF signal values includes identifying phase shifts in the pulse based on the time series of phases; and implementing the phase shifts as discontinuous time shifts in a phase of the digital IF signal values. The digital IF signal values include a time series of I-quadrature signal values; and a time series of Q-quadrature signal values. The time series of Q-quadrature signal values are phase-shifted relative to the time series of I-quadrature signal values. The time series of I-quadrature signal values and the time series of Q-quadrature signal values each include a respective DC offset configured to reduce LO leakage.

Implementations of the second example may include one or more of the following features. The method further includes generating a plurality of sets of digital IF signal values based on a plurality of pulses in a pulse sequence; and generating a plurality of magnetic resonance control signals based on the plurality of sets of digital IF signal values. The method includes parsing the pulse sequence to identify the plurality of pulses, a plurality of time delays, and one or more acquisition periods in the pulse sequence.

Implementations of the second example may include one or more of the following features. The pulse profile includes a first pulse profile for a first pulse in a pulse sequence. The digital IF signal values are first digital IF signal values. The analog IF electrical signals are first analog IF electrical signals. The magnetic resonance control signal is a first magnetic resonance control signal. The pulse sequence includes the first pulse, a time delay after the first pulse, and a second pulse after the time delay. The method includes, by operation of the computer system, identifying a second pulse profile for the second pulse; determining a phase shift based on the duration of the time delay and a cycle time of an intermediate frequency; and generating second digital IF signal values corresponding to the second pulse profile. The phase shift is applied to the second digital IF signal values. The method further includes storing the second digital IF signal values in the memory unit; after generating the first analog IF electrical signals based on the first digital IF signal values, implementing the time delay; after the time delay, generating a second analog IF electrical signal based on the second digital IF signal values; mixing the second analog IF electrical signal with local oscillator (LO) electrical signals to produce a second magnetic resonance control signal; and delivering the second magnetic resonance control signal to the resonator unit in the magnetic resonance system.

Implementations of the second example may include one or more of the following features. The method includes identifying a plurality of pulse profiles for the pulse; generating sets of digital IF signal values for the respective pulse profiles; and combining the sets of digital IF signal values to produce a set of digital IF signal values representing a multiple-resonance pulse. Each of the pulse profiles corresponding to a distinct resonance frequency; and Each set of digital IF signal values having a distinct intermediate frequency.

Implementations of the second example may include one or more of the following features. The pulse includes a multiple-resonance pulse. The pulse profile includes a first pulse profile corresponding to a first resonance frequency of the pulse. The method includes, by operation of the computer system, identifying a second pulse profile corresponding to a second resonance frequency of the pulse; generating first digital IF signal values based on the first pulse profile, the first digital IF signal values having a first intermediate frequency; generating second digital IF signal values based on the second pulse profile, the second digital IF signal values having a distinct, second intermediate frequency; and generating the digital IF signal values by superposing the first digital IF signal values and the second digital IF signal values.

Implementations of the second example may include one or more of the following features. The method includes receiving the magnetic resonance control signal at the resonator unit; and by operation of the resonator unit, generating a control field in response to the magnetic resonance control signal. The method further includes receiving a magnetic resonance detection signal from the resonator unit, down-converting a frequency of the magnetic resonance detection signal to an intermediate frequency; generating digital magnetic resonance detection signal values based on the down-converted magnetic resonance detection signal; and, by operation of the computer system, demodulating the digital magnetic resonance detection signal values at the intermediate frequency.

In a third example, a magnetic resonance system includes a computer system, a digital-to-analog converter (DAC) device, a mixer device and circuitry. The computer system is configured to identify a pulse profile for a pulse; generate digital intermediate frequency (IF) signal values based on the pulse profile; and store the digital IF signal values. The DAC unit is configured to convert the digital IF signal values to analog IF electrical signals. The mixer device is configured to mix the analog IF electrical signals with local oscillator (LO) electrical signals to produce a magnetic resonance control signal. The circuitry is configured to deliver the magnetic resonance control signal to a resonator unit.

Implementations of the third example may include one or more of the following features. The pulse profile defines a time series of amplitudes and a time series of phases for the pulse. Generating the digital IF signal values includes identifying phase shifts in the pulse based on the time series of phases; and implementing the phase shifts as discontinuous time shifts in a phase of the digital IF signal values. The digital IF signal values include a time series of I-quadrature signal values; and a time series of Q-quadrature signal values. The time series of Q-quadrature signal values are phase-shifted relative to the time series of I-quadrature signal values. The time series of I-quadrature signal values and the time series of Q-quadrature signal values each include a respective DC offset configured to reduce LO leakage.

Implementations of the third example may include one or more of the following features. The computer system is configured to generate a plurality of sets of digital IF signal values based on a plurality of pulses in a pulse sequence. The mixer device is configured to generate a plurality of magnetic resonance control signals based on the plurality of sets of digital IF signal values. The computer system is configured to parse the pulse sequence to identify the plurality of pulses, a plurality of delays and one or more acquisition periods in the pulse sequence.

Implementations of the third example may include one or more of the following features. The pulse profile includes a first pulse profile for a first pulse in a pulse sequence. The digital IF signal values are first digital IF signal values. The analog IF electrical signals are first analog IF electrical signals. The magnetic resonance control signal is a first magnetic resonance control signal. The pulse sequence includes the first pulse, a time delay after the first pulse, and a second pulse after the time delay. The computer system is configured to identify a second pulse profile for the second pulse; determine a phase shift based on the duration of the time delay and a cycle time of an intermediate frequency; generate second digital IF signal values corresponding to the second pulse profile, wherein the phase shift is applied to the second digital IF signal values; store the second digital IF signal values in the memory unit; and after generating the first analog IF electrical signals based on the first digital IF signal values, implement the time delay. The DAC unit is configured to, after the time delay, generate a second analog IF electrical signal based on the second digital IF signal values. The mixer device is configured to mix the second analog IF electrical signal with local oscillator (LO) electrical signals to produce a second magnetic resonance control signal. The circuitry is configured to deliver the second magnetic resonance control signal to the resonator unit in the magnetic resonance system.

Implementations of the third example may include one or more of the following features. The computer system is configured to identify a plurality of pulse profiles for the pulse; generate sets of digital IF signal values for the respective pulse profiles; and combine the sets of digital IF signal values to produce a set of digital IF signal values representing a multiple-resonance pulse. Each of the pulse profiles corresponding to a distinct resonance frequency; and each set of digital IF signal values having a distinct intermediate frequency.

Implementations of the third example may include one or more of the following features. The pulse includes a multiple-resonance pulse. The pulse profile includes a first pulse profile corresponding to a first resonance frequency of the pulse. The computer system is configured to identify a second pulse profile corresponding to a second resonance frequency of the pulse; generate first digital IF signal values based on the first pulse profile, the first digital IF signal values having a first intermediate frequency; generate second digital IF signal values based on the second pulse profile, the second digital IF signal values having a distinct, second intermediate frequency; and generate the digital IF signal values by superposing the first digital IF signal values and the second digital IF signal values.

Implementations of the third example may include one or more of the following features. The magnetic resonance system includes a superheterodyne spectrometer that includes the mixer device. The resonator unit is configured to receive the magnetic resonance control signal at the resonator unit; and generate a control field in response to the magnetic resonance control signal.

The mixer device is a first mixer deice. The circuitry is a first circuitry. The magnetic resonance system includes a second mixer device, an analog to digital converter (ADC) device, and second circuitry. The second mixer device is configured to receive a magnetic resonance detection signal from the resonator unit; and down-convert a frequency of the magnetic resonance detection signal to an intermediate frequency. The ADC unit is configured to generate digital magnetic resonance detection signal values based on the down-converted magnetic resonance detection signal. The second circuitry is configured to deliver the magnetic resonance detection signal to the second mixer device; and deliver the down-converted magnetic resonance detection signal to the ADC unit. The computer system is further configured to demodulate the digital magnetic resonance detection signal values at the intermediate frequency.

In a fourth example, a method of operating a magnetic resonance system includes by operation of a computer system, obtaining pulse sequence information corresponding to a pulse sequence to be executed by the magnetic resonance system, the magnetic resonance system including a control unit, digital-to-analog converter (DAC) units, analog-to-digital converter (ADC) units, and digital input/output (DIO) units; and generating a hardware control sequence based on the pulse sequence information, the hardware control sequence including timestamps and hardware control values for respective time segments in the pulse sequence, the hardware control values for each time segment configured to control operation of the DAC units, the ADC units and the DIO units; storing the hardware control sequence in a memory unit; and executing the pulse sequence in the magnetic resonance system. Executing the pulse sequence includes controlling, by operation of the control unit, operation of the DAC units, the ADC units and the DIO units according to the hardware control sequence.

Implementations of the fourth example may include one or more of the following features. Controlling operation of the DAC units, the ADC units, and the DIO units according to the hardware control sequence includes receiving a clock signal; and delaying the clock signal for each respective hardware component to synchronize their operations. Controlling operation of the DAC units, the ADC units and the DIO units includes causing operation of the DAC units during a first subset of the time segments; and causing operation of the ADC units during a second subset of the time segments. The first subset of the time segments corresponds to pulses in the pulse sequence; and the second subset of time segments corresponds to acquisitions in the pulse sequence. Controlling operation of the DAC units, the ADC units and the DIO units includes synchronizing transmission electronics to produce magnetic resonance control signals during the first subset of the time segments; and synchronizing receiver electronics to process magnetic resonance detection signals during the second subset of the time segments.

Implementations of the fourth example may include one or more of the following features. The hardware control sequence comprises pulse identifiers for a subset of the time segments corresponding to pulses in the pulse sequence, and each pulse identifier indicates a memory address where digital IF signal values are stored. Executing the pulse sequence includes iteratively :identifying one of the timestamps in the hardware control sequence; comparing a clock signal with the identified timestamp; upon detecting a match between the clock signal and the identified timestamp, sending digital control signals according to the hardware control values associated with the identified timestamp.

Implementations of the fourth example may include one or more of the following features. Storing the hardware control sequence in a memory unit includes storing a series of commands in a buffer memory unit, the commands corresponding to the respective time segments in the pulse sequence. Each command includes the timestamp and the hardware control values for a respective one of the time segments; and executing the pulse sequence includes executing the commands stored in the buffer memory unit. Executing the commands includes reading the commands from the buffer memory unit; and for each command, generating hardware control signals according to the hardware control values in the command at the time designated by the timestamp in the command. The method includes signal averaging the pulse sequence by iteratively executing the series of commands, and filling the buffer memory unit with multiple copies of the series of commands, wherein each copy is executed multiple times. One of the commands in the series of commands includes a delay period between iterations of the pulse sequence.

In a fifth example, a magnetic resonance system includes digital-to-analog converter (DAC) units; analog-to-digital converter (ADC) units; digital input/output (DIO) units; a memory unit configured to store a hardware control sequence; a data processing apparatus configured to: obtain pulse sequence information corresponding to a pulse sequence; and generate the hardware control sequence based on the pulse sequence information; and a control unit configured to control operation of the DAC units, the ADC units and the DIO units according to the hardware control sequence when the pulse sequence is executed in the magnetic resonance system. The hardware control sequence includes timestamps and hardware control values for respective time segments in the pulse sequence; and the hardware control values for each time segment are configured to control operation of the DAC units, the ADC units and the DIO units.

Implementations of the fifth example may include one or more of the following features. The control unit is configured to receive a clock signal; and delay the clock signal for each respective hardware component to synchronize their operations. The control unit is configured to cause operation of the DAC units during a first subset of the time segments; and cause operation of the ADC units during a second subset of the time segments. The first subset of the time segments corresponds to pulses in the pulse sequence; and the second subset of time segments corresponds to acquisitions in the pulse sequence. The control unit is configured to synchronize transmission electronics to produce magnetic resonance control signals during the first subset of the time segments; and synchronize receiver electronics to process magnetic resonance detection signals during the second subset of the time segments.

Implementations of the fifth example may include one or more of the following features. The hardware control sequence includes pulse identifiers for a subset of the time segments corresponding to pulses in the pulse sequence, and each pulse identifier indicates a memory address where digital IF signal values are stored. Executing the pulse sequence includes iteratively identifying one of the timestamps in the hardware control sequence; comparing a clock signal with the identified timestamp; upon detecting a match between the clock signal and the identified timestamp, sending digital control signals according to the hardware control values associated with the identified timestamp.

Implementations of the fifth example may include one or more of the following features. The data processing apparatus includes a buffer memory unit configured to store a series of commands. The series of commands corresponds to the respective time segments in the pulse sequence. Each command includes the timestamp and the hardware control values for a respective one of the time segments. Executing the pulse sequence includes executing the series of commands stored in the buffer memory unit. Executing the commands includes reading the commands from the buffer memory unit; and for each command, generating hardware control signals according to the hardware control values in the command at the time designated by the timestamp in the command. The data processing apparatus is configured to signal average the pulse sequence by iteratively executing the series of commands. The data processing apparatus is configured to fill the buffer memory unit with multiple copies of the series of commands, wherein each copy is executed multiple times. One of the commands in the series of commands comprises a delay period between iterations of the pulse sequence.

In a sixth example, a method of operating a magnetic resonance system includes accessing digital intermediate frequency (IF) signal values for a multiple-resonance pulse. The digital IF signal values include a plurality of intermediate frequencies associated with a plurality of resonance frequencies of the multiple-resonance pulse. The method further includes generating analog IF electrical signals based on the digital IF signal values; generating a multiple-resonance magnetic resonance control signal based on the analog IF electrical signals; and delivering the multiple-resonance magnetic resonance control signal to a resonator unit in the magnetic resonance system.

Implementations of the sixth example may include one or more of the following features. The method further includes, by operation of a computer system, identifying a first pulse profile corresponding to a first resonance frequency of the multiple-resonance pulse; identifying a second pulse profile corresponding to a second resonance frequency of the multiple-resonance pulse; generating first digital IF signal values based on the first pulse profile, the first digital IF signal values having a first intermediate frequency; generating second digital IF signal values based on the second pulse profile, the second digital IF signal values having a distinct, second intermediate frequency; and generating the digital IF signal value by superposing the first digital IF signal values and the second digital IF signal values. The multiple-resonance pulse includes a double resonance pulse in a double electron-electron resonance (DEER) measurement. The first resonance frequency corresponds to a first electron resonance frequency; and the second resonance frequency corresponds to a second electron resonance frequency.

Implementations of the sixth example may include one or more of the following features. The method includes receiving the magnetic resonance control signal at the resonator unit; and by operation of the resonator unit, generating a control field in response to the magnetic resonance control signal. The method further includes receiving a magnetic resonance detection signal from the resonator unit; down-converting the magnetic resonance detection signal; generating digital magnetic resonance detection signal values based on the down-converted magnetic resonance detection signal; and, by operation of the computer system, demodulating the digital magnetic resonance detection signal values at the first intermediate frequency; and demodulating the digital magnetic resonance detection signal values at the second intermediate frequency.

In a seventh example, a magnetic resonance system includes a computer system, a digital to analog converter (DAC) device, a mixer device, and circuitry. The computer system is configured to access digital intermediate frequency (IF) signal values for a multiple-resonance pulse. The digital IF signal values comprising a plurality of intermediate frequencies associated with a plurality of resonance frequencies of the multiple-resonance pulse. The DAC unit is configured to convert the digital IF signal values to analog IF electrical signals. The mixer device is configured to mix the analog IF electrical signals with local oscillator (LO) electrical signals to produce a magnetic resonance control signal. The circuitry is configured to deliver the multiple-resonance magnetic resonance control signal to a resonator unit.

Implementations of the seventh example may include one or more of the following features. The computer system is configured to identify a first pulse profile corresponding to a first resonance frequency of the multiple-resonance pulse; identify a second pulse profile corresponding to a second resonance frequency of the multiple-resonance pulse; generate first digital IF signal values based on the first pulse profile, the first digital IF signal values having a first intermediate frequency; generate second digital IF signal values based on the second pulse profile, the second digital IF signal values having a distinct, second intermediate frequency; and generate the digital IF signal value by superposing the first digital IF signal values and the second digital IF signal values. The multiple-resonance pulse comprises a double resonance pulse in a double electron-electron resonance (DEER) measurement. The first resonance frequency corresponds to a first electron resonance frequency; and the second resonance frequency corresponds to a second electron resonance frequency.

Implementations of the seventh example may include one or more of the following features. The resonator unit is configured to receive the magnetic resonance control signal at the resonator unit; and generate a control field in response to the magnetic resonance control signal. The mixer device is a first mixer device. The circuitry is a first circuitry. The magnetic resonance system includes a second mixer device, an analog to digital converter (ADC) device, and second circuitry. The second mixer device is configured to receive a magnetic resonance detection signal from the resonator unit; and down-converting the magnetic resonance detection signal. The ADC unit is configured to generate digital magnetic resonance detection signal values based on the down-converted magnetic resonance detection signal. The second circuitry is configured to deliver the magnetic resonance detection signal to the second mixer device; and deliver the down-converted magnetic resonance detection signal to the ADC unit. The computer system is further configured to demodulate the digital magnetic resonance detection signal values at the first intermediate frequency; and demodulate the digital magnetic resonance detection signal values at the second intermediate frequency.

While this specification contains many details, these should not be understood as limitations on the scope of what may be claimed, but rather as descriptions of features specific to particular examples. Certain features that are described in this specification or shown in the drawings in the context of separate implementations can also be combined. Conversely, various features that are described or shown in the context of a single implementation can also be implemented in multiple embodiments separately or in any suitable sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the implementations described above should not be understood as requiring such separation in all implementations, and it should be understood that the described program components and systems can generally be integrated together in a single product or packaged into multiple products.

A number of examples have been described. Nevertheless, it will be understood that various modifications can be made. Accordingly, other examples are within the scope of the following claims.

Further embodiments are provided in the following enumerated clauses:

1. A magnetic resonance system comprising:

data processing apparatus that generates digital intermediate frequency (IF) signal information based on a pulse profile, wherein the digital IF signal information is configured to suppress an image sideband in a magnetic resonance control signal; and
a superheterodyne spectrometer system that generates the magnetic resonance control signal based on the digital IF signal information.

2. The magnetic resonance system of clause 1, wherein the digital IF signal information specifies one or more phase shifts based on a time series of phases specified by the pulse profile.

3. The magnetic resonance system of clause 1, wherein the digital IF signal information comprises:

a time series of I-quadrature signal values; and
a time series of Q-quadrature signal values, wherein the time series of Q-quadrature signal values are phase-shifted relative to the time series of I-quadrature signal values.

4. The magnetic resonance system of clause 3, wherein generating the magnetic resonance control signal comprises mixing analog IF electrical signals with local oscillator (LO) signals, and the time series of I-quadrature signal values and the time series of Q-quadrature signal values each comprise a DC offset configured to reduce leakage of the LO signals.

5. The magnetic resonance system of clause 1, wherein the digital IF signal information includes a plurality of sets of digital IF signal values based on a plurality of pulses in a pulse sequence, and the superheterodyne spectrometer system is configured to generate a plurality of magnetic resonance control signals based on the plurality of sets of digital IF signal values.

6. A method of operating a magnetic resonance system, the method comprising:

by operation of a computer system:

identifying a pulse profile for a pulse to be generated by the magnetic resonance system;
generating digital intermediate frequency (IF) signal values based on the pulse profile;
storing the digital IF signal values in a memory unit; and
generating analog IF electrical signals based on the digital IF signal values;

mixing the analog IF electrical signals with local oscillator (LO) electrical signals to produce a magnetic resonance control signal; and
delivering the magnetic resonance control signal to a resonator unit in the magnetic resonance system.

7. The method of clause 6, wherein the pulse profile defines a time series of amplitudes and a time series of phases for the pulse.

8. The method of clause 7, wherein generating the digital IF signal values comprises:

identifying phase shifts in the pulse based on the time series of phases; and
implementing the phase shifts as discontinuous time shifts in a phase of the digital IF signal values.

9. The method of clause 6, wherein the digital IF signal values comprise:

a time series of I-quadrature signal values; and
a time series of Q-quadrature signal values, wherein the time series of Q-quadrature signal values are phase-shifted relative to the time series of I-quadrature signal values.

10. The method of clause 9, wherein the time series of I-quadrature signal values and the time series of Q-quadrature signal values each comprise a DC offset configured to reduce leakage of the LO signals.

11. The method of clause 6, comprising:

generating a plurality of sets of digital IF signal values based on a plurality of pulses in a pulse sequence; and generating a plurality of magnetic resonance control signals based on the plurality of sets of digital IF signal values.

12. The method of clause 11, comprising parsing the pulse sequence to identify the plurality of pulses, a plurality of time delays, and one or more acquisition periods in the pulse sequence.

13. The method of clause 6, wherein:

the pulse profile comprises a first pulse profile for a first pulse in a pulse sequence, the digital IF signal values are first digital IF signal values, the analog IF electrical signals are first analog IF electrical signals, the magnetic resonance control signal is a first magnetic resonance control signal;
the pulse sequence comprises the first pulse, a time delay after the first pulse, and a second pulse after the time delay, and
the method comprises:

by operation of the computer system:

identifying a second pulse profile for the second pulse;
determining a phase shift based on the duration of the time delay and a cycle time of an intermediate frequency; and
generating second digital IF signal values corresponding to the second pulse profile, wherein the phase shift is applied to the second digital IF signal values;

storing the second digital IF signal values in the memory unit;
after generating the first analog IF electrical signals based on the first digital IF signal values, implementing the time delay;
after the time delay, generating a second analog IF electrical signal based on the second digital IF signal values;
mixing the second analog IF electrical signal with local oscillator (LO) electrical signals to produce a second magnetic resonance control signal; and
delivering the second magnetic resonance control signal to the resonator unit in the magnetic resonance system.

14. The method of clause 6, comprising:

identifying a plurality of pulse profiles for the pulse, each of the pulse profiles corresponding to a distinct resonance frequency;
generating sets of digital IF signal values for the respective pulse profiles, each set of digital IF signal values having a distinct intermediate frequency; and
combining the sets of digital IF signal values to produce a combined set of digital IF signal values representing a multiple-resonance pulse.

15. The method of clause 6, wherein:

the pulse comprises a multiple-resonance pulse,
the pulse profile comprises a first pulse profile corresponding to a first resonance frequency of the pulse, and
the method comprises, by operation of the computer system:

identifying a second pulse profile corresponding to a second resonance frequency of the pulse;
generating first digital IF signal values based on the first pulse profile, the first digital IF signal values having a first intermediate frequency;

generating second digital IF signal values based on the second pulse profile, the second digital IF signal values having a distinct, second intermediate frequency; and

generating the digital IF signal values by superposing the first digital IF signal values and the second digital IF signal values.

16. The method of clause 6, wherein the magnetic resonance system comprises a superheterodyne spectrometer that mixes the analog IF electrical signals with the LO electrical signal.

17. The method of clause 6, comprising:

receiving the magnetic resonance control signal at the resonator unit; and
by operation of the resonator unit, generating a control field based on the magnetic resonance control signal.

18. The method of clause 17, comprising:

receiving a magnetic resonance detection signal from the resonator unit;
down-converting a frequency of the magnetic resonance detection signal to an intermediate frequency;
generating digital magnetic resonance detection signal values based on the down-converted magnetic resonance detection signal; and
by operation of the computer system,
demodulating the digital magnetic resonance detection signal values at the intermediate frequency.

19. A magnetic resonance system comprising:

a computer system configured to:

identify a pulse profile for a pulse;
generate digital intermediate frequency (IF) signal values based on the pulse profile; and
store the digital IF signal values;

a digital-to-analog converter (DAC) device configured to convert the digital IF signal values to analog IF electrical signals;
a mixer device configured to mix the analog IF electrical signals with local oscillator (LO) electrical signals to produce a magnetic resonance control signal; and
circuitry configured to deliver the magnetic resonance control signal to a resonator unit.

20. The magnetic resonance system of clause 19, wherein the pulse profile defines a time series of amplitudes and a time series of phases for the pulse.

21. The magnetic resonance system of clause 20, wherein generating the digital IF signal values comprises:

identifying phase shifts in the pulse based on the time series of phases; and
implementing the phase shifts as discontinuous time shifts in a phase of the digital IF signal values.

22. The magnetic resonance system of clause 19, wherein the digital IF signal values comprise:

a time series of I-quadrature signal values; and
a time series of Q-quadrature signal values, wherein the time series of Q-quadrature signal values are phase-shifted relative to the time series of I-quadrature signal values.

23. The magnetic resonance system of clause 22, wherein the time series of I-quadrature signal values and the time series of Q-quadrature signal values each comprise a DC offset configured to reduce leakage of the LO signals.

24. The magnetic resonance system of clause 19, wherein the computer system is configured to generate a plurality of sets of digital IF signal values based on a plurality of pulses in a pulse sequence.

25. The magnetic resonance system of clause 19, wherein the computer system is configured to parse the pulse sequence to identify the plurality of pulses, a plurality of delays and one or more acquisition periods in the pulse sequence.

26. The magnetic resonance system of clause 19, wherein:

the pulse profile comprises a first pulse profile for a first pulse in a pulse sequence, the digital IF signal values are first digital IF signal values, the analog IF electrical signals are first analog IF electrical signals, the magnetic resonance control signal is a first magnetic resonance control signal;
the pulse sequence comprises the first pulse, a time delay after the first pulse, and a second pulse after the time delay; and
the computer system is configured to:

identify a second pulse profile for the second pulse;
determine a phase shift based on the duration of the time delay and a cycle time of an intermediate frequency;
generate second digital IF signal values corresponding to the second pulse profile, wherein the phase shift is applied to the second digital IF signal values;
store the second digital IF signal values in the memory unit; and
after generating the first analog IF electrical signals based on the first digital IF signal values, implement the time delay;

the DAC unit is configured to, after the time delay, generate a second analog IF electrical signal based on the second digital IF signal values;
the mixer device is configured to mix the second analog IF electrical signal with local oscillator (LO) electrical signals to produce a second magnetic resonance control signal; and
the circuitry is configured to deliver the second magnetic resonance control signal to the resonator unit in the magnetic resonance system.

27. The magnetic resonance system of clause 19, wherein the computer system is configured to:

identify a plurality of pulse profiles for the pulse, each of the pulse profiles corresponding to a distinct resonance frequency;
generate sets of digital IF signal values for the respective pulse profiles, each set of digital IF signal values having a distinct intermediate frequency; and
combine the sets of digital IF signal values to produce a combined set of digital IF signal values representing a multiple-resonance pulse.

28. The magnetic resonance system of clause 19, wherein:

the pulse comprises a multiple-resonance pulse,
the pulse profile comprises a first pulse profile corresponding to a first resonance frequency of the pulse, and
the computer system is configured to:

identify a second pulse profile corresponding to a second resonance frequency of the pulse;
generate first digital IF signal values based on the first pulse profile, the first digital IF signal values having a first intermediate frequency;
generate second digital IF signal values based on the second pulse profile, the second digital IF signal values having a distinct, second intermediate frequency; and
generate the digital IF signal values by superposing the first digital IF signal values and the second digital IF signal values.

29. The magnetic resonance system of clause 19, comprising a superheterodyne spectrometer that comprises the mixer device.

30. The magnetic resonance system of clause 19, comprising the resonator unit, wherein the resonator unit is configured to:

receive the magnetic resonance control signal at the resonator unit; and
generate a control field in response to the magnetic resonance control signal.

31. The magnetic resonance system of clause 19, wherein the mixer device is a first mixer deice, the circuitry is a first circuitry, the magnetic resonance system comprises:

a second mixer device configured to:

receive a magnetic resonance detection signal from the resonator unit; and
down-convert a frequency of the magnetic resonance detection signal to an intermediate frequency;

an analog-to-digital converter (ADC) device configured generate digital magnetic resonance detection signal values based on the down-converted magnetic resonance detection signal; and
second circuitry configured to:

deliver the magnetic resonance detection signal to the second mixer device; and
deliver the down-converted magnetic resonance detection signal to the ADC unit; and

the computer system is further configured to demodulate the digital magnetic resonance detection signal values at the intermediate frequency.

32. A method of operating a magnetic resonance system, the method comprising: by operation of a computer system:

obtaining pulse sequence information corresponding to a pulse sequence to be executed by the magnetic resonance system, the magnetic resonance system comprising a control unit, digital-to-analog converter (DAC) units, analog-to-digital converter (ADC) units, and digital input/output (DIO) units; and
generating a hardware control sequence based on the pulse sequence information, the hardware control sequence comprising timestamps and hardware control values for respective time segments in the pulse sequence, the hardware control values for each time segment configured to control operation of the DAC units, the ADC units and the DIO units;

storing the hardware control sequence in a memory unit; and
executing the pulse sequence in the magnetic resonance system, wherein executing the pulse sequence comprises controlling, by operation of the control unit, operation of the DAC units, the ADC units and the DIO units according to the hardware control sequence.

33. The method of clause 32, wherein controlling operation of the DAC units, the ADC units, and the DIO units according to the hardware control sequence comprises:

receiving a clock signal; and
delaying the clock signal for each respective hardware component to synchronize their operations.

34. The method of clause 32, wherein controlling operation of the DAC units, the ADC units and the DIO units comprises:

causing operation of the DAC units during a first subset of the time segments, wherein the first subset of the time segments correspond to pulses in the pulse sequence; and
causing operation of the ADC units during a second subset of the time segments, wherein the second subset of time segments correspond to acquisitions in the pulse sequence.

35. The method of clause 34, wherein controlling operation of the DAC units, the ADC units and the DIO units comprises:

synchronizing transmission electronics to produce magnetic resonance control signals during the first subset of the time segments; and
synchronizing receiver electronics to process magnetic resonance detection signals during the second subset of the time segments.

36. The method of clause 32, wherein the hardware control sequence comprises pulse identifiers for a subset of the time segments corresponding to pulses in the pulse sequence, and each pulse identifier indicates a memory address where digital IF signal values are stored.

37. The method of clause 32, wherein executing the pulse sequence comprises iteratively:

identifying one of the timestamps in the hardware control sequence;
comparing a clock signal with the identified timestamp; and
upon detecting a match between the clock signal and the identified timestamp, sending digital control signals according to the hardware control values associated with the identified timestamp.

38. The method of clause 32, wherein:

storing the hardware control sequence in a memory unit comprises storing a series of commands in a buffer memory unit, the series of commands corresponding to the respective time segments in the pulse sequence, each command comprising the timestamp and the hardware control values for a respective one of the time segments; and
executing the pulse sequence comprises executing the commands stored in the buffer memory unit.

39. The method of clause 38, wherein executing the commands comprises:

reading the commands from the buffer memory unit; and
for each command, generating hardware control signals according to the hardware control values in the command at the time designated by the timestamp in the command.

40. The method of clause 38, comprising signal averaging the pulse sequence by iteratively executing the series of commands.

41. The method of clause 38, comprising filling the buffer memory unit with multiple copies of the series of commands, wherein each copy is executed multiple times.

42. The method of clause 38, wherein one of the commands in the series of commands comprises a delay period between iterations of the pulse sequence.

43. A magnetic resonance system comprising:

digital-to-analog converter (DAC) units;
analog-to-digital converter (ADC) units;
digital input/output (DIO) units;
a memory unit configured to store a hardware control sequence;
a data processing apparatus configured to:

obtain pulse sequence information corresponding to a pulse sequence; and
generate the hardware control sequence based on the pulse sequence information, the hardware control sequence comprising timestamps and hardware control values for respective time segments in the pulse sequence, the hardware control values for each time segment configured to control operation of the DAC units, the ADC units and the DIO units; and

a control unit configured to control operation of the DAC units, the ADC units and the DIO units according to the hardware control sequence when the pulse sequence is executed in the magnetic resonance system.

44. The system of clause 43, wherein the control unit is configured to:

receive a clock signal; and
delay the clock signal for each respective hardware component to synchronize their operations.

45. The system of clause 43, wherein the control unit is configured to:

cause operation of the DAC units during a first subset of the time segments, wherein the first subset of the time segments correspond to pulses in the pulse sequence; and
cause operation of the ADC units during a second subset of the time segments, wherein the second subset of time segments correspond to acquisitions in the pulse sequence.

46. The system of clause 43, wherein the control unit is configured to:

synchronize transmission electronics to produce magnetic resonance control signals during the first subset of the time segments; and
synchronize receiver electronics to process magnetic resonance detection signals during the second subset of the time segments.

47. The system of clause 43, wherein the hardware control sequence comprises pulse identifiers for a subset of the time segments corresponding to pulses in the pulse sequence, and each pulse identifier indicates a memory address where digital IF signal values are stored.

48. The system of clause 43, wherein executing the pulse sequence comprises iteratively:

identifying one of the timestamps in the hardware control sequence;
comparing a clock signal with the identified timestamp;
upon detecting a match between the clock signal and the identified timestamp, sending digital control signals according to the hardware control values associated with the identified timestamp.

49. The system of clause 43, wherein the data processing apparatus comprises a buffer memory unit configured to store a series of commands, the series of commands corresponding to the respective time segments in the pulse sequence, each command comprising the timestamp and the hardware control values for a respective one of the time segments; and executing the pulse sequence comprises executing the series of commands stored in the buffer memory unit.

50. The system of clause 49, wherein executing the commands comprises:

reading the commands from the buffer memory unit; and
for each command, generating hardware control signals according to the hardware control values in the command at the time designated by the timestamp in the command.

51. The system of clause 49, wherein the data processing apparatus is configured to signal average the pulse sequence by iteratively executing the series of commands.

52. The system of clause 49, wherein the data processing apparatus is configured to fill the buffer memory unit with multiple copies of the series of commands, wherein each copy is executed multiple times.

53. The system of clause 49, wherein one of the commands in the series of commands comprises a delay period between iterations of the pulse sequence.

54. A method of operating a magnetic resonance system, the method comprising:

accessing digital intermediate frequency (IF) signal values for a multiple-resonance pulse, the digital IF signal values comprising a plurality of intermediate frequencies associated with a plurality of resonance frequencies of the multiple-resonance pulse;
generating analog IF electrical signals based on the digital IF signal values;
generating a multiple-resonance magnetic resonance control signal based on the analog IF electrical signals; and
delivering the multiple-resonance magnetic resonance control signal to a resonator unit in the magnetic resonance system.

55. The method of clause 54, comprising, by operation of a computer system:

identifying a first pulse profile corresponding to a first resonance frequency of the multiple-resonance pulse;
identifying a second pulse profile corresponding to a second resonance frequency of the multiple-resonance pulse;
generating first digital IF signal values based on the first pulse profile, the first digital IF signal values having a first intermediate frequency;
generating second digital IF signal values based on the second pulse profile, the second digital IF signal values having a distinct, second intermediate frequency; and

generating the digital IF signal value by superposing the first digital IF signal values and the second digital IF signal values.

56. The method of clause 55, wherein the multiple-resonance pulse comprises a double resonance pulse in a double electron-electron resonance (DEER) measurement.

57. The method of clause 56, wherein the first resonance frequency corresponds to a first electron resonance frequency, and the second resonance frequency corresponds to a second electron resonance frequency.

58. The method of clause 54, comprising:

receiving the magnetic resonance control signal at the resonator unit; and
by operation of the resonator unit, generating a control field in response to the magnetic resonance control signal.

59. The method of clause 54, comprising:

receiving a magnetic resonance detection signal from the resonator unit;
down-converting the magnetic resonance detection signal;
generating digital magnetic resonance detection signal values based on the down-converted magnetic resonance detection signal; and
by operation of the computer system,

demodulating the digital magnetic resonance detection signal values at a first intermediate frequency; and
demodulating the digital magnetic resonance detection signal values at a second intermediate frequency.

60. A magnetic resonance system comprising:

a control unit configured to access digital intermediate frequency (IF) signal values for a multiple-resonance pulse, the digital IF signal values comprising a plurality of intermediate frequencies associated with a plurality of resonance frequencies of the multiple-resonance pulse;
a digital to analog converter (DAC) device configured to convert the digital IF signal values to analog IF electrical signals;
a mixer device configured to mix the analog IF electrical signals with local oscillator (LO) electrical signals to produce a magnetic resonance control signal; and
circuitry configured to deliver the multiple-resonance magnetic resonance control signal to a resonator unit.

61. The magnetic resonance system of clause 60, comprising a computer system configured to:

identify a first pulse profile corresponding to a first resonance frequency of the multiple-resonance pulse;
identify a second pulse profile corresponding to a second resonance frequency of the multiple-resonance pulse;
generate first digital IF signal values based on the first pulse profile, the first digital IF signal values having a first intermediate frequency;
generate second digital IF signal values based on the second pulse profile, the second digital IF signal values having a distinct, second intermediate frequency; and
generate the digital IF signal value by superposing the first digital IF signal values and the second digital IF signal values.

62. The magnetic resonance system of clause 61, wherein the multiple-resonance pulse comprises a double resonance pulse in a double electron-electron resonance (DEER) measurement.

63. The magnetic resonance system of clause 62, wherein the first resonance frequency corresponds to a first electron resonance frequency; and the second resonance frequency corresponds to a second electron resonance frequency.

64. The magnetic resonance system of clause 60, wherein the resonator unit is configured to:

receive the magnetic resonance control signal at the resonator unit; and
generate a control field in response to the magnetic resonance control signal.

65. The magnetic resonance system of clause 60, wherein the mixer device is a first mixer device, the circuitry is a first circuitry, the magnetic resonance system comprises:

a second mixer device configured to:

receive a magnetic resonance detection signal from the resonator unit; and
down-converting the magnetic resonance detection signal;

an analog to digital converter (ADC) device configured to generate digital magnetic resonance detection signal values based on the down-converted magnetic resonance detection signal; and
second circuitry configured to:

deliver the magnetic resonance detection signal to the second mixer device; and
deliver the down-converted magnetic resonance detection signal to the ADC unit; and

the computer system is further configured to:

demodulate the digital magnetic resonance detection signal values at a first intermediate frequency; and
demodulate the digital magnetic resonance detection signal values at a second intermediate frequency.

**Claims**

1. A method of operating a magnetic resonance system, the method comprising:

by operation of a computer system:

obtaining pulse sequence information corresponding to a pulse sequence to be executed by the magnetic resonance system, the magnetic resonance system comprising a control unit, digital-to-analog converter (DAC) units, analog-to-digital converter (ADC) units, and digital input/output (DIO) units; and
generating a hardware control sequence based on the pulse sequence information, the hardware control sequence comprising timestamps and hardware control values for respective time segments in the pulse sequence, the hardware control values for each time segment configured to control operation of the DAC units, the ADC units and the DIO units;

storing the hardware control sequence in a memory unit; and
executing the pulse sequence in the magnetic resonance system, wherein executing the pulse sequence comprises controlling, by operation of the control unit, operation of the DAC units, the ADC units and the DIO units according to the hardware control sequence.

2. The method of claim 1, wherein controlling operation of the DAC units, the ADC units, and the DIO units according to the hardware control sequence comprises:

receiving a clock signal; and
delaying the clock signal for each respective hardware component to synchronize their operations.

3. The method of claim 1, wherein controlling operation of the DAC units, the ADC units and the DIO units comprises:

causing operation of the DAC units during a first subset of the time segments, wherein the first subset of the time segments correspond to pulses in the pulse sequence; and
causing operation of the ADC units during a second subset of the time segments, wherein the second subset of time segments correspond to acquisitions in the pulse sequence.

4. The method of claim 3, wherein controlling operation of the DAC units, the ADC units and the DIO units comprises:

synchronizing transmission electronics to produce magnetic resonance control signals during the first subset of the time segments; and
synchronizing receiver electronics to process magnetic resonance detection signals during the second subset of the time segments.

5. The method of claim 1, wherein the hardware control sequence comprises pulse identifiers for a subset of the time segments corresponding to pulses in the pulse sequence, and each pulse identifier indicates a memory address where digital IF signal values are stored.

6. The method of claim 1, wherein executing the pulse sequence comprises iteratively:

identifying one of the timestamps in the hardware control sequence;
comparing a clock signal with the identified timestamp; and
upon detecting a match between the clock signal and the identified timestamp, sending digital control signals according to the hardware control values associated with the identified timestamp.

7. The method of claim 1, wherein:

storing the hardware control sequence in a memory unit comprises storing a series of commands in a buffer memory unit, the series of commands corresponding to the respective time segments in the pulse sequence, each command comprising the timestamp and the hardware control values for a respective one of the time segments; and
executing the pulse sequence comprises executing the commands stored in the buffer memory unit.

8. The method of claim 7, wherein executing the commands comprises:

reading the commands from the buffer memory unit; and
for each command, generating hardware control signals according to the hardware control values in the command at the time designated by the timestamp in the command.

9. The method of claim 7, comprising signal averaging the pulse sequence by iteratively executing the series of commands.

10. The method of claim 7, comprising filling the buffer memory unit with multiple copies of the series of commands, wherein each copy is executed multiple times.

11. The method of claim 7, wherein one of the commands in the series of commands comprises a delay period between iterations of the pulse sequence.

12. A magnetic resonance system comprising:

digital-to-analog converter (DAC) units;
analog-to-digital converter (ADC) units;
digital input/output (DIO) units;
a memory unit configured to store a hardware control sequence;
a data processing apparatus configured to:

obtain pulse sequence information corresponding to a pulse sequence; and
generate the hardware control sequence based on the pulse sequence information, the hardware control sequence comprising timestamps and hardware control values for respective time segments in the pulse sequence, the hardware control values for each time segment configured to control operation of the DAC units, the ADC units and the DIO units; and

a control unit configured to control operation of the DAC units, the ADC units and the DIO units according to the hardware control sequence when the pulse sequence is executed in the magnetic resonance system.

13. The system of claim 12, wherein the control unit is configured to:

receive a clock signal; and
delay the clock signal for each respective hardware component to synchronize their operations.

14. The system of claim 12, wherein the control unit is configured to:

cause operation of the DAC units during a first subset of the time segments, wherein the first subset of the time segments correspond to pulses in the pulse sequence; and
cause operation of the ADC units during a second subset of the time segments, wherein the second subset of time segments correspond to acquisitions in the pulse sequence.

15. The system of claim 12, wherein the control unit is configured to:

synchronize transmission electronics to produce magnetic resonance control signals during the first subset of the time segments; and
synchronize receiver electronics to process magnetic resonance detection signals during the second subset of the time segments.

16. The system of claim 12, wherein the hardware control sequence comprises pulse identifiers for a subset of the time segments corresponding to pulses in the pulse sequence, and each pulse identifier indicates a memory address where digital IF signal values are stored.

17. The system of claim 12, wherein executing the pulse sequence comprises iteratively:

identifying one of the timestamps in the hardware control sequence;
comparing a clock signal with the identified timestamp;
upon detecting a match between the clock signal and the identified timestamp, sending digital control signals according to the hardware control values associated with the identified timestamp.

18. The system of claim 12, wherein the data processing apparatus comprises a buffer memory unit configured to store a series of commands, the series of commands corresponding to the respective time segments in the pulse sequence, each command comprising the timestamp and the hardware control values for a respective one of the time segments; and executing the pulse sequence comprises executing the series of commands stored in the buffer memory unit.

19. The system of claim 18, wherein executing the commands comprises:

reading the commands from the buffer memory unit; and
for each command, generating hardware control signals according to the hardware control values in the command at the time designated by the timestamp in the command.

20. The system of claim 18, wherein the data processing apparatus is configured to signal average the pulse sequence by iteratively executing the series of commands.

21. The system of claim 18, wherein the data processing apparatus is configured to fill the buffer memory unit with multiple copies of the series of commands, wherein each copy is executed multiple times.

22. The system of claim 18, wherein one of the commands in the series of commands comprises a delay period between iterations of the pulse sequence.

FIG. 1

FIG. 2A

EP 4 729 973 A2

FIG. 2B

FIG. 3A

EP 4 729 973 A2

330

| Frame N |
|---|
| Frame N-1 |
| ... |
| Frame 2 |
| Frame 1 |
| Frame 0 |

332

332

| DIO | DAC | ADC | Timestamp |
|---|---|---|---|

334A    334B  334C    334D

FIG. 3B

400

Identifying a pulse profile — 402

Generating digital IF signal values — 404

Storing the digital IF signal values — 406

Converting the digital IF signal values
to analog IF electrical signals — 408

Generating a magnetic resonance
control signal — 410

FIG. 4

FIG. 5A

FIG. 5B

FIG. 5C

EP 4 729 973 A2

FIG. 6A

FIG. 6B

EP 4 729 973 A2

Fourier Transform of Upconverted Pulse

632

FIG. 6C

FIG. 7A

FIG. 7B

FIG. 7C

EP 4 729 973 A2

Demodulated IF Pulse: Phase

732

724

Phase [Deg]

150
100
50
-50
-100
-150

500   1000   1500   2000

Time [ns]

Demodulated IF Pulse: Amplitude

730

724

Amplitude

1.0
0.8
0.6
0.4
0.2

0   500   1000   1500   2000

Time [ns]

FIG. 7D

FIG. 7E

FIG. 7F

EP 4 729 973 A2

FIG. 7G

EP 4 729 973 A2

770

**Phase of Refocusing Pulse for τ = 1000 ns vs 996 ns**

772

774

774

772

772

774

Amplitude

150

100

50

-50

-100

-150

1480  1500  1520  1540  1560  1580  1600

Time [ns]

FIG. 7H

FIG. 7I

DAC1 Pulse 1 Memory

DAC2 Pulse 1 Memory

DAC1 Pulse 2 Memory

DAC2 Pulse 2 Memory

Time [ns]

Amplitude

800

802

804

806

FIG. 8

FIG. 9A

910

| Time | Action |
|---|---|
| 0 | Enable input to DIOs |
| 25 | Enable input to DACs |
| 125 | Disable input to DACs |
| 150 | Disable input to DIOs |
| 1100 | Enable input to DIOs |
| 1125 | Enable input to DACs |
| 1225 | Disable input to DACs |
| 1250 | Disable input to DIOs |
| 1325 | Enable input to DIOs; enable output from ADCs |
| 11325 | Disable input to DIOs; disable output from ADCs |

FIG. 9B

EP 4 729 973 A2

1002

## Example ADC Data at IF

1004

## Demodulated ADC Data

1006

## Phase-Corrected ADC Data

## FIG. 10

FIG. 11A

FIG. 11B

EP 4 729 973 A2

FIG. 11C

EP 4 729 973 A2

FIG. 12A

FIG. 12B

EP 4 729 973 A2

FIG. 12C

EP 4 729 973 A2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63489834